(19) Europäisches Patentamt
European Patent Office
Office européen des brevets

(11) **EP 4 376 004 A1**

(12) **EUROPEAN PATENT APPLICATION**

(43) Date of publication:
**29.05.2024 Bulletin 2024/22**

(21) Application number: **23212542.7**

(22) Date of filing: **28.11.2023**

(51) International Patent Classification (IPC):
**G11C 7/10** $^{(2006.01)}$    **G11C 11/54** $^{(2006.01)}$
**G11C 8/08** $^{(2006.01)}$    **G11C 13/00** $^{(2006.01)}$
**G06F 7/544** $^{(2006.01)}$    **G06N 3/063** $^{(2023.01)}$

(52) Cooperative Patent Classification (CPC):
**G11C 7/1006; G06F 7/5443; G06N 3/063;**
**G11C 8/08; G11C 11/54; G11C 13/0028;**
**G11C 13/0061; G11C 13/0069;** G11C 11/418;
G11C 11/419; G11C 13/0004; G11C 2013/0092

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **28.11.2022 US 202217994817**

(71) Applicant: **STMicroelectronics S.r.l.**
**20864 Agrate Brianza (MB) (IT)**

(72) Inventors:
• **CARISSIMI, Marcella**
**24048 TREVIOLO (BG) (IT)**
• **ZAMBOTTI, Paolo Sergio**
**20132 MILANO (IT)**
• **ZURLA, Riccardo**
**20082 BINASCO (MI) (IT)**

(74) Representative: **Studio Torta S.p.A.**
**Via Viotti, 9**
**10121 Torino (IT)**

(54) **IN-MEMORY COMPUTATION SYSTEM WITH COMPACT STORAGE OF SIGNED COMPUTATIONAL WEIGHT DATA**

(57) An IMC circuit includes a memory cells arranged in matrix (112). Computational weights for an IMC operation are stored in groups of cells ($115_{AB}$; $215_{AB}$). Each row of groups of cells includes a positive (WL<B>+) and negative (WL<B>-) word line. Each column of groups of cells includes a bit line (BL). The IMC operation includes a first elaboration where a word line signal is applied to the positive/negative word line of the group of cells depending on the positive/negative sign, respectively, of the coefficient data, with a positive MAC output on the bit line. In a second elaboration, a word line signal is applied to the negative/positive word line of the group of cells depending on the positive/negative sign, respectively, of the coefficient data, with a negative MAC output on the bit line. The IMC operation result is obtained from a difference between the positive and negative MAC operations.

FIG. 4

EP 4 376 004 A1

**Description**

TECHNICAL FIELD

The present invention relates to an in-memory computation circuit and, in particular, to supporting a compact storage of signed computational weight data and the handling of feature or coefficient data in multiple bit formats.

BACKGROUND

An in-memory computation (IMC) system stores information in the bit cells of a memory array and performs calculations at the bit cell level. An example of a calculation performed by an IMC system is a multiply and accumulate (MAC) operation where an input array of numbers (X values, also referred to as the feature or coefficient data) are multiplied by an array of computational weights (g values) stored in the memory and the products are added together to produce an output array of numbers (Y values).

$$\begin{bmatrix} Y_1 \\ Y_2 \\ \vdots \\ Y_m \end{bmatrix} = \begin{bmatrix} g_{11} & g_{12} & \cdots & g_{1n} \\ g_{21} & g_{22} & \cdots & g_{2n} \\ \vdots & \vdots & \vdots & \vdots \\ g_{m1} & g_{m2} & \cdots & g_{mn} \end{bmatrix} \times \begin{bmatrix} X_1 \\ X_2 \\ \vdots \\ X_n \end{bmatrix}$$

$$\begin{cases} Y_1 = g_{11} \times X_1 + g_{12} \times X_2 + \cdots + g_{1n} \times X_n \\ Y_2 = g_{21} \times X_1 + g_{22} \times X_2 + \cdots + g_{2n} \times X_n \\ \qquad\qquad\qquad \vdots \\ Y_m = g_{m1} \times X_1 + g_{m2} \times X_2 + \cdots + g_{mn} \times X_n \end{cases}$$

By performing these calculations at the bit cell level in the memory, the IMC system does not need to move data back and forth between a memory device and a computing device. Thus, the limitations associated with data transfer bandwidth between devices are obviated and the computation can be performed with lower power consumption.

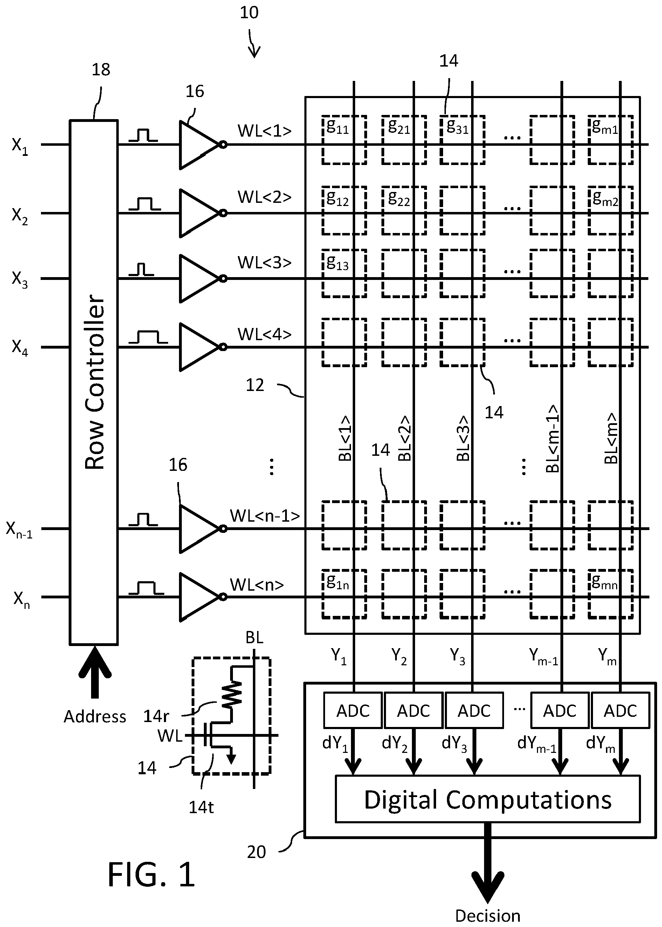

Reference is made to Figure 1 which shows a schematic diagram of an analog in-memory computation circuit 10. The circuit 10 utilizes a memory array 12 formed by a plurality of memory cells 14 arranged in a matrix format having m columns and n rows. Each memory cell 14 is programmed to store a bit of data $g_{ab}$, where a is an integer from 1 to m and b is an integer from 1 to n, relating to the computational weights (also referred to as kernel data) for an in-memory compute operation. Each bit of the computational weight has either a logic "1" value or a logic "0" value which is represented, for example, by a programmable transconductance in the memory cell 14.

In an embodiment of the memory array 12, each memory cell 14 comprises a phase change memory (PCM) cell formed by a select circuit (MOSFET transistor, BJT transistor, diode device, etc.) 14t operating as a switching element and a variable resistive element 14r providing a programmable transconductance. In the case of a MOSFET transistor for the select circuit 14t, the control node (gate) of the MOSFET transistor is connected to the word line WL. The source-drain path of the MOSFET transistor is connected in series with the variable resistive element 14r between the bit line BL and a reference node (for example, a source line or ground). More specifically, a drain of the MOSFET transistor is connected to a first terminal of the variable resistive element 14r, the source of the MOSFET transistor is connected to the reference node, and the second terminal of the variable resistive element 14r is connected to the bit line BL.

As is well known to those skilled in the art, a PCM-type memory cell 14 is configured to store data using a phase change material (such as a chalcogenide) that is capable of stably transitioning between amorphous and crystalline phases according to an amount of heat transferred thereto. The amorphous and crystalline phases exhibit two or more distinct resistances (corresponding to the variable resistive element 14r), in other words two or more distinct transconductances, which are used to distinguish two or more distinct logic states programmable into the memory cell. The amorphous phase exhibits a relatively higher resistance (i.e., a lower transconductance) and thus the current sunk from the bit line BL by the memory cell programmed in this state when selected by assertion of the word line signal at the gate of the select circuit 14t is relatively smaller. Conversely, the crystalline phase exhibits a relatively lower resistance (i.e., a higher transconductance) and thus the current sunk from the bit line BL by the memory cell programmed in this state when selected by assertion of the word line signal at the gate of the select circuit 14t is relatively larger.

In an embodiment for a specific, but non-limiting, example for two distinct logic states: the amorphous phase may represent programming of the memory cell to logic "0" (or reset state) for the associated coefficient weight and the crystalline phase may represent programming of the memory cell to logic "1" (or set state) for the associated coefficient weight.

It will be understood that other memory cell types could instead be used for the array 12. For example, magnetoresistive random access memory (MRAM) cells or resistive random access memory (RRAM) cells could be used. The memory cell may alternatively comprise a static random access memory (SRAM) cell.

Each memory cell 14 includes a word line WL and a bit line BL. The memory cells 14 in a common row of the matrix are connected to each other through a common word line WL<b>. The memory cells 14 in a common column of the matrix are connected to each other through a common bit line BL<a>.

Each word line WL<b> is driven by a word line driver circuit 16 with a pulsed word line signal generated by a row controller circuit 18. The word line driver circuit 16 may be implemented as a CMOS driver circuit (for example, a series connected p-channel and n-channel MOSFET transistor pair forming a logic inverter circuit).

The row controller circuit 18 receives an address signal (Address) for the in-memory compute operation and in response thereto performs the function of selecting which ones of the word lines WL<1> to WL<n> are to be simultaneously accessed (or actuated) in parallel during an analog in-memory compute operation. The row controller circuit 18 further receives the feature or coefficient data $X_b$ for the in-memory compute operation and in response thereto controls, for each corresponding actuated word line WL<b>, the width (i.e., the on time $T_{ON}$) of the generated pulsed word line signal. This functionality is a form of a pulse width modulation (PWM) control for the applied word line signals dependent on the digital value of the received feature or coefficient data X.

Figure 1 illustrates, by way of example only, the simultaneous actuation of all word lines WL<1>, ..., WL<n> in response to the received Address with pulsed word line signals having pulse widths set by the digital value of the corresponding coefficient data $X_1$, ..., $X_n$. It will, of course, be understood that the analog in-memory compute operation may instead utilize a simultaneous actuation of fewer than all rows of the memory array (through either Address signal selection or through a zero value for a given coefficient data $X_b$).

The analog signal $Y_a$ developed on the bit line BL<a> is dependent on the logic state of the bits of the computational weight $g_{ab}$ stored in the b=1 to n memory cells 14 of the column and the widths of the pulsed word line signals applied to the word lines WL<1>, ..., WL<n> for those memory cells 14. More specifically, it will be understood that each memory cell 14 contributes a bit line BL discharge current that is proportional to $X_b \times g_{ab}$. So, in the example shown in Figure 1 where the word line signals 16 are simultaneously applied to the word lines WL<1>, ..., WL<n>, the analog signal Yi developed on the bit line BL<1> is proportional to the sum of discharge currents due to $X_1 \times g_{11}$, $X_2 \times g_{12}$, ..., and $X_n \times g_{1n}$.

A column processing circuit 20 senses and samples the analog signal $Y_a$ on each bit line BL<a> for the m columns and converts the analog signal to a corresponding digital signal $dY_a$ using analog-to-digital converter circuitry. Although Figure 1 illustrates that one analog-to-digital converter (ADC) is provided for each column, it will be understood that ADC resources in the column processing circuit 20 could instead be shared by multiple columns using time division multiplexing. The column processing circuit 20 may further include digital signal processing circuitry for performing digital computations and calculations on the digital signals $dY_a$ to generate a decision output for the in-memory compute operation.

Although not explicitly shown in Figure 1, it will be understood that the circuit 10 further includes conventional row decode, column decode, and read-write circuits known to those skilled in the art for use in connection with writing bits of data (for example, the computational weight data) to, and reading bits of data from, the memory cells 14 of the memory array 12. This operation is referred to as a conventional memory access mode and is distinguished from the analog in-memory compute operation discussed above.

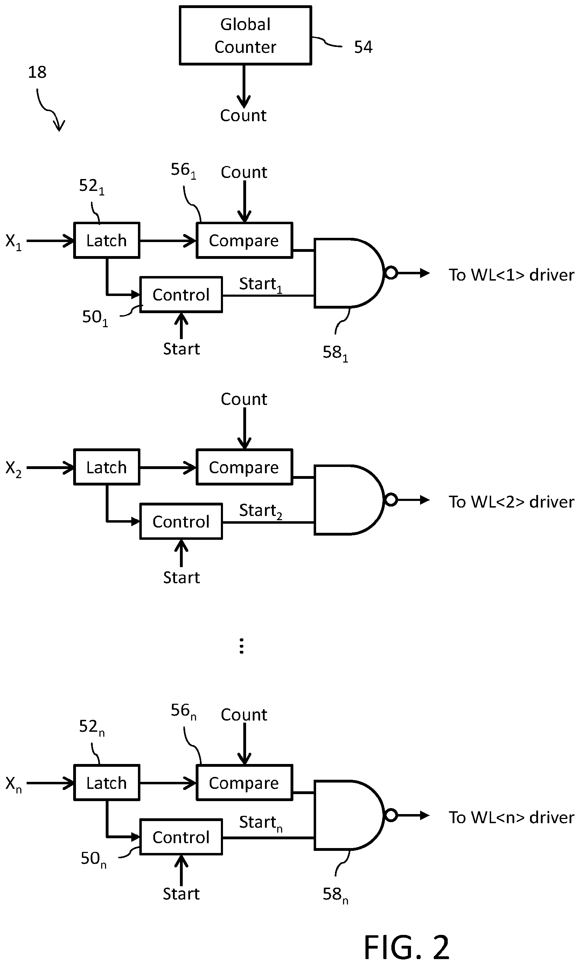

Reference is now made to Figure 2 which shows a circuit diagram for the row controller 18. A latch circuit $52_b$ is provided for each word line WL<b> to latch the corresponding digital value of the digital value of the coefficient data $X_b$. For example, this latching operation may be dependent on the address signal (Address), which is decoded to control the latch circuit $52_b$ to latch the coefficient data $X_b$ for the corresponding word line WL<b>. A control circuit $50_b$ is provided for each word line WL<b>. The control circuit $50_b$ receives a global start signal (Start) and the associated coefficient data $X_b$ from latch circuit $52_b$. If the latch value is zero, the global start signal is blocked and no word line signal is asserted for the analog in-memory compute operation. Otherwise, the latch circuit $52_b$ will assert its output signal $Start_b$ to control the corresponding word line WL<b> to be asserted during the analog in-memory compute operation. A global counter circuit 54 increments a count value (Count) starting from a zero reset at the beginning of the in-memory compute operation. A compare circuit $56_b$ for each word line WL<b> is coupled to the latch circuit $52_b$ and compares the count value Count to the latched digital value of the coefficient data $X_b$. The output of the compare circuit $56_b$ is asserted when the count value Count meets or exceeds the latched digital value. A combinational logic circuit $58_b$ logically combines the outputs of the decoder circuit $50_b$ and the match circuit $56_b$ to generate the pulsed word line signal for application to the driver circuit 16 of the word line WL<b>. In an embodiment, the combinational logic circuit $58_b$ is a logic NAND gate.

Operation of the circuitry within the row controller 18 is as follows: At the beginning of the in-memory compute operation, the digital values of the coefficient data $X_1$ to $X_n$ are latched by the latch circuits $52_1$ to $52_n$, and the global counter 54 is reset. If the latched data value is non-zero, the $Start_b$ signal output of the decoder circuit $50_b$ is asserted logic high (in response to the global start signal) and the output of the NAND gate $58_b$ transitions to logic high to provide the leading edge of the word line signal pulse. The global counter 54 then begins incrementing the Count value. When the incrementing Count value meets or exceeds the digital value of the coefficient data $X_b$ latched by the latch circuit $52_b$, the finish signal output of the compare circuit $56_b$ is asserted logic high and the output of the NAND gate $58_b$ transitions to logic low to provide the trailing edge of the word line signal pulse. The pulse width (i.e., the on time Torr) of the generated pulsed word line signal is thus dependent on the amount of time needed during the in-memory compute operation for the incrementing Count value to reach the digital value of the coefficient data $X_b$.

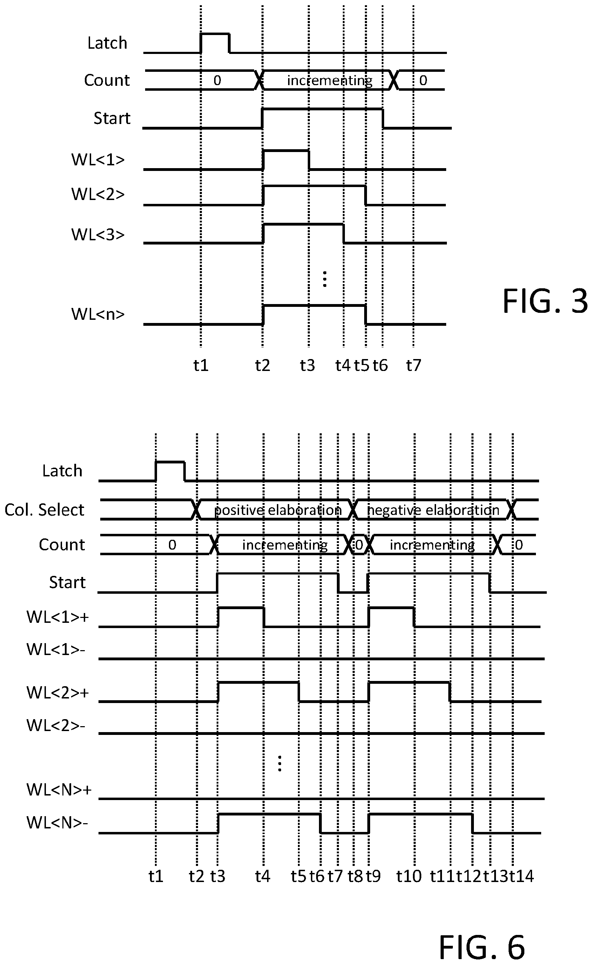

Reference is now made to Figure 3 which shows a simplified timing diagram for operation of the circuit 10 in connection with one overall in-memory compute operation including one elaboration. At time t1, a latch control signal is asserted to cause the latch circuits $52_1$ to $52_n$ to latch the digital values of the coefficient data $X_1$ to $X_n$, and the overall in-memory compute operation begins. We assume here the example discussed above and shown in Figure 1 where there is a simultaneous selection of all rows of memory cells 14 in response to the loaded non-zero coefficient data, and the simultaneous actuation at time t2 of the word lines WL<1> to WL<n> corresponding to feature or coefficient data $X_1$ to $X_n$ with pulsed word line signals in response to the Start$_b$ signals. Also at time t2, the previously reset Count value begins to increment. At time t3, the incrementing Count value meets or exceeds the digital value of the coefficient data $X_1$, and the word line signal pulse on the word line WL< 1> terminates. At time t4, the incrementing Count value meets or exceeds the digital value of the coefficient data $X_3$, and the word line signal pulse on the word line WL<3> terminates. At time t5, the incrementing Count value meets or exceeds the digital value of the coefficient data $X_2$ and $X_N$, and the word line signal pulses on the word lines WL<2> and WL<N> terminates. At time t6, the Start$_b$ signals are deasserted and the Count value is reset. At time t7, the analog signals $Y_1$ to $Y_m$ on the bit lines BL<1 > to BL<m> are sampled for analog-to-digital conversion and the overall in-memory compute operation ends.

It is recognized that the value for feature or coefficient data can be signed and that the value for the computational weight data can also be signed. There exists a need in the art to support performance of signed MAC operations.

SUMMARY

According to the present invention, there is provided an in-memory computation circuit, as defined in the appended claims.

BRIEF DESCRIPTION OF THE DRAWINGS

For a better understanding of the embodiments, reference will now be made by way of example only to the accompanying figures in which:

Figure 1 is a schematic diagram of an embodiment for an in-memory computation circuit;
Figure 2 shows a circuit diagram for a row controller circuit used by the in-memory computation circuit of Figure 1;
Figure 3 is a timing diagram illustrating an in-memory compute operation using the circuit of Figure 1;
Figure 4 is a schematic diagram of an embodiment for an in-memory computation circuit;
Figure 5 shows a circuit diagram for a row controller circuit used by the in-memory computation circuit of Figure 4;
Figure 6 is a timing diagram illustrating an in-memory compute operation using the circuit of Figure 4;
Figure 7 is a schematic diagram of an embodiment for an in-memory computation circuit;
Figure 8 shows a circuit diagram for a row controller circuit used by the in-memory computation circuit of Figure 7;
Figure 9 is a timing diagram illustrating an in-memory compute operation using the circuit of Figure 7;
Figure 10 shows a circuit diagram for an embodiment of a row controller circuit used by the in-memory computation circuit of Figure 7; and
Figure 11 is a timing diagram illustrating an in-memory compute operation using the circuit of Figure 7.

DETAILED DESCRIPTION OF THE DRAWINGS

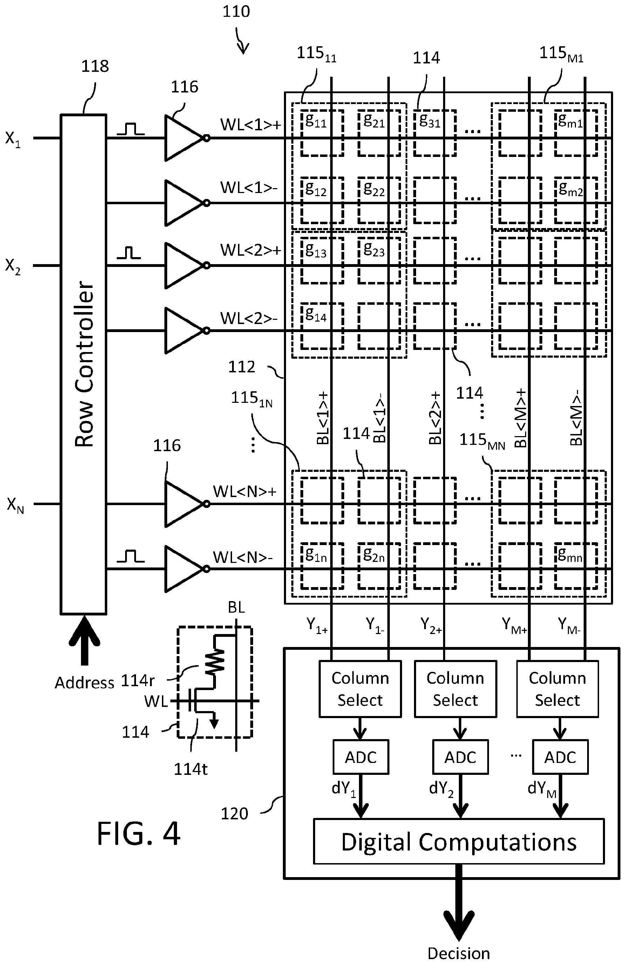

Reference is now made to Figure 4 which shows a schematic diagram of an in-memory computation circuit 110. The circuit 110 utilizes a memory array 112 formed by a plurality of memory cells 114 arranged in a matrix format having m columns and n rows. The array 112 is arranged to include groups $115_{11}$ to $115_{MN}$ of memory cells 114, wherein each group $115_{AB}$ includes four memory cells arranged in a 2x2 matrix across two rows and two columns of the array 112, where A is an integer from 1 to M and B is an integer from 1 to N. With this arrangement, there are N rows of groups $115_{AB}$ and M columns of groups $115_{AB}$ (where N=n/2 and M=m/2). Although the memory cells 114 of a group $115_{AB}$ are shown to be located in adjacent ones of the m columns of the array 112, it will be understood that this is by way of example only to ease the illustration and that in a preferred implementation the cells will most likely be separated from each other using a column multiplexing format as is well known to those skilled in the art.

Each group $115_{AB}$ of memory cells 114 stores a signed computational weight (also referred to as kernel data) for an in-memory compute operation. Each memory cell 114 can be programmed to store a bit of data $g_{ab}$, where a is an integer from 1 to m and b is an integer from 1 to n, for the signed computational weight of the group $115_{AB}$. Each bit of data has either a logic "1" or a logic "0" value which is represented, for example, by a programmable transconductance in the memory cell 114. A signed computational weight of "+1" for a given group $115_{AB}$ is represented by programming logic "1" in the memory cells 114 of the main diagonal of the 2x2 matrix (for example, see $g_{11}$=1 and $g_{22}$=1 of group $115_{11}$), and programming logic "0" in the memory cells 114 of the antidiagonal of the 2x2 matrix (for example, see $g_{12}$=0 and $g_{21}$=0 of group $115_{11}$) as illustrated here: $\begin{bmatrix} 1 & 0 \\ 0 & 1 \end{bmatrix}$, this being referred to in the art as the identity matrix. A signed computational weight of "-1" for a given group $115_{AB}$ is represented by programming logic "0" in the memory cells 114 of the main diagonal of the 2x2 matrix (for example, see gn=0 and $g_{22}$=0) and programming logic "1" in the memory cells 114 of the antidiagonal of the 2x2 matrix (for example, see $g_{12}$=1 and $g_{21}$=1 of group $115_{11}$) as illustrated here: $\begin{bmatrix} 0 & 1 \\ 1 & 0 \end{bmatrix}$, this being referred to in the art as the exchange (or backward identity) matrix. A signed computational weight of "0" for a given group $115_{AB}$ is represented by programming logic "0" in all memory cells of the 2x2 matrix (for example, see $g_{11}$=0, $g_{22}$=0, $g_{12}$=0 and $g_{21}$=0 of group $115_{11}$) as illustrated here: $\begin{bmatrix} 0 & 0 \\ 0 & 0 \end{bmatrix}$, this being referred to in the art as the zero matrix.

In an embodiment of the memory array 112, each memory cell 114 comprises a phase change memory (PCM) cell formed by a select circuit (MOSFET transistor, BJT transistor, diode device, etc.) 114t operating as a switching element and a variable resistive element 114r providing a programmable transconductance. In the case of a MOSFET transistor for the select circuit 114t, the control node (gate) of the MOSFET transistor is connected to the word line WL. The source-drain path of the MOSFET transistor is connected in series with the variable resistive element 114r between the bit line BL and a reference node (for example, a source line or ground). More specifically, a drain of the MOSFET transistor is connected to a first terminal of the variable resistive element 114r, the source of the MOSFET transistor is connected to the reference node, and the second terminal of the variable resistive element 114r is connected to the bit fine BL.

As is well known to those skilled in the art, a PCM-type memory cell 114 is configured to store data using a phase change material (such as a chalcogenide) that is capable of stably transitioning between amorphous and crystalline phases according to an amount of heat transferred thereto. The amorphous and crystalline phases exhibit two or more distinct resistances (corresponding to the variable resistive element 114r), in other words two or more distinct transconductances, which are used to distinguish two or more distinct logic states programmable into the memory cell. The amorphous phase exhibits a relatively higher resistance (i.e., a lower transconductance) and thus the current sunk from the bit line BL by the memory cell programmed in this state when selected by assertion of the word line signal at the gate of the select circuit 114t is relatively smaller. Conversely, the crystalline phase exhibits a relatively lower resistance (i.e., a higher transconductance) and thus the current sunk from the bit line BL by the memory cell programmed in this state when selected by assertion of the word line signal at the gate of the select circuit 114t is relatively larger.

In an embodiment for a specific, but non-limiting, example for two distinct logic states: the amorphous phase may represent programming of the memory cell to logic "0" (or reset state) for the associated coefficient weight and the crystalline phase may represent programming of the memory cell to logic "1" (or set state) for the associated coefficient weight.

It will be understood that other memory cell types could instead be used for the array 112. For example, magnetoresistive random access memory (MRAM) cells or resistive random access memory (RRAM) cells could be used. The memory cell may alternatively comprise a static random access memory (SRAM) cell.

Each memory cell 114 includes a word line WL and a bit line BL. The memory cells 114 in a common row of the matrix are connected to each other through a common word line WL. The groups $115_{AB}$ of memory cells 114 in a common row of groups $115_{AB}$ are connected to each other through a positive word line WL<B>+ and a negative word line WL<B>- (which form a word line pair for the common row of groups $115_{AB}$). More specifically, the positive word line WL<B>+ is connected to the upper two memory cells in the 2x2 matrix for the group (for example, see WL<1>+ for gn and $g_{21}$ of group $115_{11}$), while the negative word line WL<B>- is connected to the lower two memory cells in the 2x2 matrix for the group (for example, see WL<1>- for $g_{12}$ and $g_{22}$ of group 115n).

The memory cells 114 in a common column of the matrix are connected to each other through a common bit line BL. The groups $115_{AB}$ of memory cells 114 in a common column of groups $115_{AB}$ are connected to each other through a positive bit line BL<A>+ and a negative bit line BL<A>- (which form a bit line pair for the common column of groups $115_{AB}$). More specifically, the positive bit line BL<A>+ is connected to the left two memory cells in the 2x2 matrix for the group (for example, see BL<1>+ for $g_{11}$ and $g_{12}$ of group $115_{11}$), while the negative bit line BL<A>- is connected to the right two memory cells in the 2x2 matrix for the group (for example, see BL<1>- for $g_{21}$ and $g_{22}$ of group 115n).

Each word line WL is driven by a word line driver circuit 116 with a pulsed word line signal generated by a row controller circuit 118. The word line driver circuit 116 may be implemented as a CMOS driver circuit (for example, a series connected p-channel and n-channel MOSFET transistor pair forming a logic inverter circuit).

The row controller circuit 118 receives the signed feature or coefficient data $X_1$ to $X_N$ for the in-memory compute operation. The row controller circuit 118 also receives an address signal (Address) for the in-memory compute operation and in response thereto selectively loads the signed feature or coefficient data $X_1$ to $X_N$ for association with the rows of groups $115_{AB}$ of memory cells 114 which are to be simultaneously selected in parallel during each elaboration of the analog in-memory compute operation. During the simultaneous access for a given elaboration, only one word line of each word line pair (WL<B>+ or WL<B>-) is actuated with a pulsed word line signal. The actuated one word line of the word line pair in each elaboration is selected based on the logic state of the sign bit of the feature or coefficient data $X_B$. For example, if the sign bit is logic 0, indicative of a positive coefficient data value, then the positive word line WL<B>+ is asserted during the elaboration. Conversely, if the sign bit is logic 1, indicative of a negative coefficient data value, then the negative word line WL<B>- is asserted during the elaboration. The row controller circuit 118 still further controls, for each corresponding actuated word line, the width (i.e., the on time $T_{ON}$) of the generated pulsed word line signal. This functionality is a form of a pulse width modulation (PWM) control for the applied word line signals dependent on the digital value of the received signed feature or coefficient data $X_B$.

In an embodiment, the signed feature or coefficient data $X_B$ is provided in multi-bit signed binary format, with a 4-bit example as set forth in the following table:

| Decimal | Binary | Decimal | Binary |
|---------|--------|---------|--------|
| 0 | 0000 | 0 | 1000 |
| +1 | 0001 | -1 | 1001 |
| +2 | 0010 | -2 | 1010 |
| +3 | 0011 | -3 | 1011 |
| +4 | 0100 | -4 | 1100 |
| +5 | 0101 | -5 | 1101 |
| +6 | 0110 | -6 | 1110 |
| +7 | 0111 | -7 | 1111 |

The use of a 4-bit format for the signed feature or coefficient data $X_B$ is just an example, it being understood that the signed feature or coefficient data $X_B$ can use any selected number of bits depending on the computation application.

It will be noted that the most significant bit of the signed binary feature or coefficient data $X_B$ provides the sign bit (logic 0 is positive, logic 1 is negative) used to control selection of the positive (WL<B>+) or negative (WL<B>-) word line of the word line pair during both of the first and second elaborations, while the remaining less significant bits provide the value specifying the pulse width duration for the word line signal applied to that selected word line of the word line pair for each elaboration.

Figure 4 illustrates, by way of example only, the simultaneous selection of all rows of groups $115_{AB}$ of memory cells 114 in response to the non-zero feature or coefficient data, and further illustrates, by way of example only, an elaboration of the in-memory compute operation including the simultaneous actuation of certain positive word lines (WL<1>+ and WL<2>+, for example) corresponding to positively signed feature or coefficient data ($X_1$ and $X_2$, for example) with pulsed word line signals having pulse widths set by the digital value of the corresponding coefficient data, along with the simultaneous actuation of certain negative word lines (WL<N>-, for example) corresponding to negatively signed feature or coefficient data ($X_N$, for example) with pulsed word line signals having pulse widths set by the digital value of the corresponding coefficient data. It will, of course, be understood that the elaboration for the analog in-memory compute operation may instead utilize a simultaneous selection of fewer than all rows of groups $115_{AB}$ of memory cells 114 (through either Address signal selection or through a zero value for the coefficient data $X_B$).

The analog signal $Y_A$ developed during the elaboration on each bit line BL is dependent on the logic state of the bit of data $g_{ab}$ for the signed computational weight stored in the memory cells 114 of the column and the widths of the pulsed word line signals applied to the word lines WL for those memory cells 114. More specifically, it will be understood that each memory cell 114 contributes a bit line BL discharge current during the elaboration that is proportional to $X_B \times g_{ab}$. So, in the example shown in Figure 3 where the word line signals are simultaneously applied to the word lines WL<1>+, WL<2>+, ..., WL<N>-, the analog signal Yi+ developed during a first (e.g., positive) elaboration on the positive bit line BL<1>+ is proportional to the sum of discharge currents due to $X_1 \times g_{11}$, $0 \times g_{12}$, $X_2 \times g_{13}$, $0 \times g_{14}$, ..., $0 \times g_{1n-1}$ and $X_N \times g_{1n}$. Likewise, the analog signal Yi- developed during a second (e.g., negative) elaboration on the negative bit line BL< 1 >- is proportional to the sum of discharge currents due to $X_1 \times g_{21}$, $0 \times g_{22}$, $X_2 \times g_{23}$, $0 \times g_{24}$, ..., $0 \times g_{2n-1}$ and $X_N \times g_{2n}$. The overall result of the in-memory compute operation is a function of the difference between the first and second elaborations.

Let's assume now, for example only, some specific signed computational weights for the groups $115_{AB}$ of memory cells 114 in this column of groups. Group $115_{11}$ is programmed with weight of -1 which is represented by the exchange matrix $\begin{bmatrix} 0 & 1 \\ 1 & 0 \end{bmatrix}$. Group $115_{12}$ is programmed with weight of 0 which is represented by the zero matrix $\begin{bmatrix} 0 & 0 \\ 0 & 0 \end{bmatrix}$. Group $115_{1N}$ is programmed with weight of +1 which is represented by the identity $\begin{bmatrix} 1 & 0 \\ 0 & 1 \end{bmatrix}$. So, for this example, the analog signal Yi+ developed on the positive bit line BL<1>+ during the first (positive) elaboration of the in-memory compute operation is proportional to the sum of discharge currents due to $X_1 \times 0$, $0 \times 1$, $X_2 \times 0$, $0 \times 0$, ..., $0 \times 1$ and $X_N \times 0$; which would result in zero discharge currents on the positive bit line BL<1>+. The analog signal $Y_{1-}$ developed on the negative bit line BL<1>- during the second (negative) elaboration of the in-memory compute operation is proportional to the sum of discharge currents due to $X_1 \times 1$, $0 \times 0$, $X_2 \times 0$, $0 \times 0$, ..., $0 \times 0$ and $X_N \times 1$; which result in a sum of discharge currents due to $X_1 \times 1$, ..., and $X_N \times 1$ on the negative bit line BL<1>-.

A column processing circuit 120 includes a column selection circuit coupled to the positive bit line BL<A>+ and negative bit line BL<A>- of each bit line pair. The column selection circuit functions as a multiplexer to selectively couple the positive bit line BL<A>+ to the ADC circuity during the first (positive) elaboration of the in-memory compute operation and then selectively couple the negative bit line BL<A>- to the ADC circuitry during the second (negative) elaboration of the in-memory compute operation. The ADC circuitry senses and samples the analog signal $Y_{A+}$ developed during the first (positive) elaboration and then senses and samples the analog signal $Y_{A-}$ developed during the second (negative) elaboration. Each of the analog signals is converted by the analog-to-digital converter circuitry to a corresponding digital signal $dY_A$. The column processing circuit 120 further includes digital signal processing circuitry for storing the resulting digital signals $dY_A$ for the two elaborations and performing digital computations and calculations on the digital signals $dY_A$ to generate a decision output for the in-memory compute operation. The further computations and calculations performed may include subtracting the digital signal $dY_A$ generated from the second (negative elaboration) from the digital signal $dY_A$ generated from the first (positive) elaboration to produce an output for the overall in-memory compute operation. Although Figure 4 illustrates that one analog-to-digital converter (ADC) is provided for each bit line pair, it will be understood that ADC resources in the column processing circuit 120 could instead be shared by multiple bit line pairs using time division multiplexing.

Although not explicitly shown in Figure 4, it will be understood that the circuit 110 further includes conventional row decode, column decode, and read-write circuits known to those skilled in the art for use in connection with writing bits of data (for example, the computational weight data) to, and reading bits of data from, the memory cells 114 of the memory array 112. This operation is referred to as a conventional memory access mode and is distinguished from the analog in-memory compute operation discussed above.

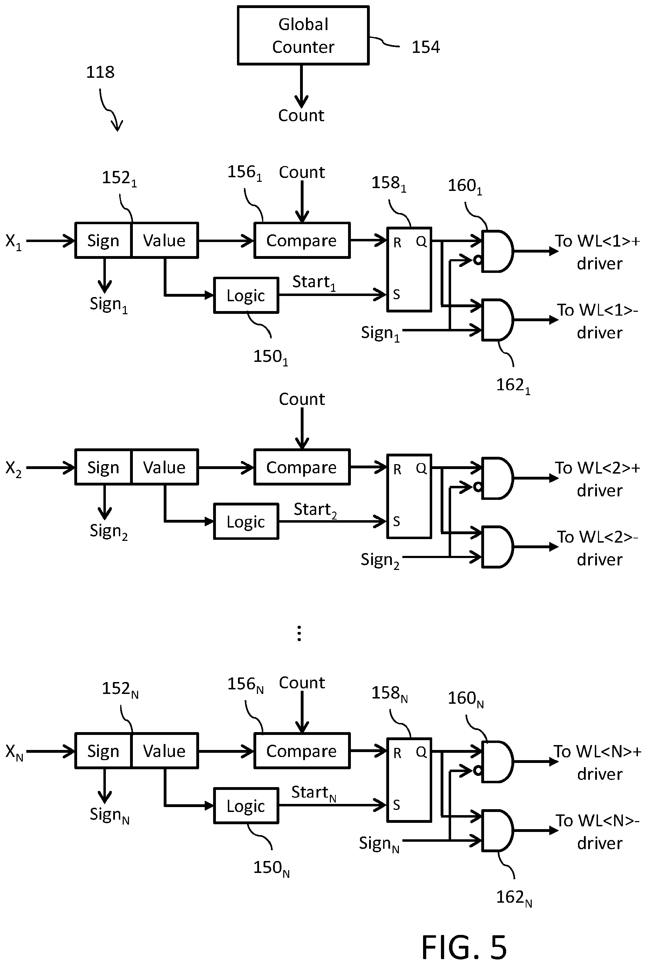

Reference is now made to Figure 5 which shows a circuit diagram for the row controller 118. A latch circuit $152_B$ is provided for each row of groups $115_{AB}$ of memory cells 114 to latch, for example in response to a decoded Address value, the corresponding sign and value of the signed digital value of the coefficient data $X_B$. A logic circuit $150_B$ is provided for each row of groups $115_{AB}$ of memory cells 114. The logic circuits $150_1$ to $150_N$ assert a start signal (Start$_B$), for example in response to a global start signal, at a beginning of each elaboration of the first (positive) and second (negative) elaborations of the in-memory compute operation. The generation of this start signal may, for example, be dependent on the corresponding signed digital value of the coefficient data $X_B$ having a non-zero value for the analog in-memory compute operation. A global counter circuit 154 increments a count value (Count) starting from a zero reset at the beginning of each elaboration for the in-memory compute operation, wherein the elaboration ends when the Count reaches a maximum value. A compare circuit $156_B$ for each row of groups $115_{AB}$ of memory cells 114 is coupled to the latch circuit $152_B$ and compares the count value Count to the latched digital value of the coefficient data $X_B$. The output of the compare circuit $156_B$ is asserted when the count value Count meets or exceeds the latched digital value. A set-reset latch circuit $158_B$ has a set (S) input coupled to receive the $Start_B$ signal output from the logic circuit $150_B$ and a reset (R) input coupled to receive the output of the compare circuit $156_B$. A combinational logic circuit $160_B$ logically combines the output (Q) of the set-reset latch circuit $158_B$ and the logical inverse of the sign bit $Sign_B$ from the latch circuit $152_B$ to generate the pulsed word line signal for application to the driver circuit 116 of the positive word line WL<B>+. A combinational logic circuit $162_B$ logically combines the output (Q) of the set-reset latch circuit $158_B$ and the sign bit $Sign_B$ from the latch circuit $152_B$ to generate the pulsed word line signal for application to the driver circuit 116 of the negative word line WL<B>-. In an embodiment, the combinational logic circuits $160_B$ and $162_B$ are logic AND gates.

Operation of the circuitry within the row controller 118 is as follows: At the beginning of the in-memory compute operation, the address signal Address is decoded to control selective loading of the digital values of the coefficient data $X_1$ to $X_N$ for latching by the latch circuits $152_1$ to $152_N$, and the global counter 154 is reset. If the digital value of the coefficient data is non-zero, the logic circuit $150_B$ indicates selection of the row of groups $115_{AB}$ of memory cells 114, the start signal $Start_B$ output of the logic circuit $150_B$ is asserted logic high at the beginning of each elaboration of the first (positive) and second (negative) elaborations, and the set-reset latch circuit $158_B$ is set with its output Q logic high. If the sign bit $Sign_B$ is logic 0, indicating that the digital value of the coefficient data $X_B$ is positive, both inputs of the AND gate $160_B$ are logic high and the output of the AND gate $160_B$ transitions to logic high to provide the leading edge of the word line signal pulse on the positive word line WL<B>+. Conversely, if the sign bit $Sign_B$ is logic 1, indicating that the digital value of the coefficient data $X_B$ is negative, both inputs of the AND gate $162_B$ are logic high and the output of the AND gate $162_B$ transitions to logic high to provide the leading edge of the word line signal pulse on the negative word line WL<B>-. The global counter 154 then begins incrementing the Count value. When the incrementing Count value meets or exceeds the digital value of the coefficient data $X_B$ latched by the latch circuit $152_B$, the output of the compare circuit $156_B$ is asserted logic high, and the set-reset latch circuit $158_B$ is reset with its output Q logic low. This logic low output is applied to both of the AND gates $160_B$ and $162_B$, and whichever output of those AND gates is logic high (corresponding to assertion of the word line signal pulse) will transition to logic low to provide the trailing edge of the word line signal pulse. The pulse width (i.e., the on time Torr) of the generated pulsed word line signal is thus dependent on the amount of time needed during the elaboration of the in-memory compute operation for the incrementing Count value to reach the digital value of the coefficient data $X_B$. When the Count reaches its maximum value, the given elaboration ends.

Reference is now made to Figure 6 which shows a simplified timing diagram for operation of the circuit 110 in connection with one overall in-memory compute operation including two separate elaborations. At time t1, a latch control signal is asserted to cause the latch circuits 152i to $152_N$ to latch the signed digital values of the coefficient data $X_1$ to $X_N$, and the overall in-memory compute operation begins. At time t2, the column select circuitry of the column processing circuit 120 selects the positive bit lines BL<A>+ through the multiplexing in connection with performing the first (positive) elaboration of the in-memory compute operation. We assume here the example discussed above and shown in Figure 4 where there is a simultaneous selection of all rows of groups $115_{AB}$ of memory cells 114 in response to the non-zero values of the coefficient data, and the simultaneous actuation in response to assertion of the $Start_B$ signals at time t3 of the word lines WL<1>+, WL<2>+ corresponding to the positive feature or coefficient data $X_1$, $X_2$ with pulsed word line signals and also the word line WL<N>- corresponding to the negative feature or coefficient data $X_N$ with a pulsed word line signal. Also at time t3, the previously reset Count value begins to increment. At time t4, the incrementing Count value meets or exceeds the digital value of the coefficient data $X_1$, and the word line signal pulse on the positive word line WL<1>+ terminates. At time t5, the incrementing Count value meets or exceeds the digital value of the coefficient data $X_2$, and the word line signal pulse on the positive word line WL<2>+ terminates. At time t6, the incrementing Count value meets or exceeds the digital value of the coefficient data $X_N$, and the word line signal pulse on the negative word line WL<N>- terminates. At time t7, the Start signal is deasserted and the Count value is reset. Additionally, the analog signals $Y_{1+}$ to $Y_{M+}$ on the positive bit lines BL< 1 >+ to BL<M>+ (selected by the column select circuit) are sampled for analog-to-digital conversion and the first (positive) elaboration of the in-memory compute operation ends.

At time t8, the column select circuitry of the column processing circuit 120 selects the negative bit lines BL<A>- through the multiplexing in connection with performing the second (negative) elaboration of the in-memory compute operation. We again assume here the example discussed above and shown in Figure 4 where there is a simultaneous selection of all rows of groups $115_{AB}$ of memory cells 114 in response to the non-zero coefficient data, and the simultaneous actuation in response to assertion of the $Start_B$ signals at time t9 of the word lines WL< 1 >+, WL<2>+ corresponding to the positive feature or coefficient data $X_1$, $X_2$ with pulsed word line signals and the word line WL<N>- corresponding to the negative feature or coefficient data $X_N$ with a pulsed word line signal. Also at time t9, the previously reset Count value begins to increment. At time t10, the incrementing Count value meets or exceeds the digital value of the coefficient data $X_1$, and the word line signal pulse on the positive word line WL<1>+ terminates. At time t11, the incrementing Count value meets or exceeds the digital value of the coefficient data $X_2$, and the word line signal pulse on the positive word line WL<2>+ terminates. At time t12, the incrementing Count value meets or exceeds the digital value of the coefficient data $X_N$, and the word line signal pulse on the negative word line WL<N>- terminates. At time t13, the Start signal is deasserted and the Count value is reset. Additionally, the analog signals Yi- to $Y_{M-}$ on the negative bit lines BL<1>- to BL<M>-(selected by the column select circuit) are sampled for analog-to-digital conversion and the second (negative) elaboration of the in-memory compute operation ends. At time t14, the overall in-memory compute operation ends.

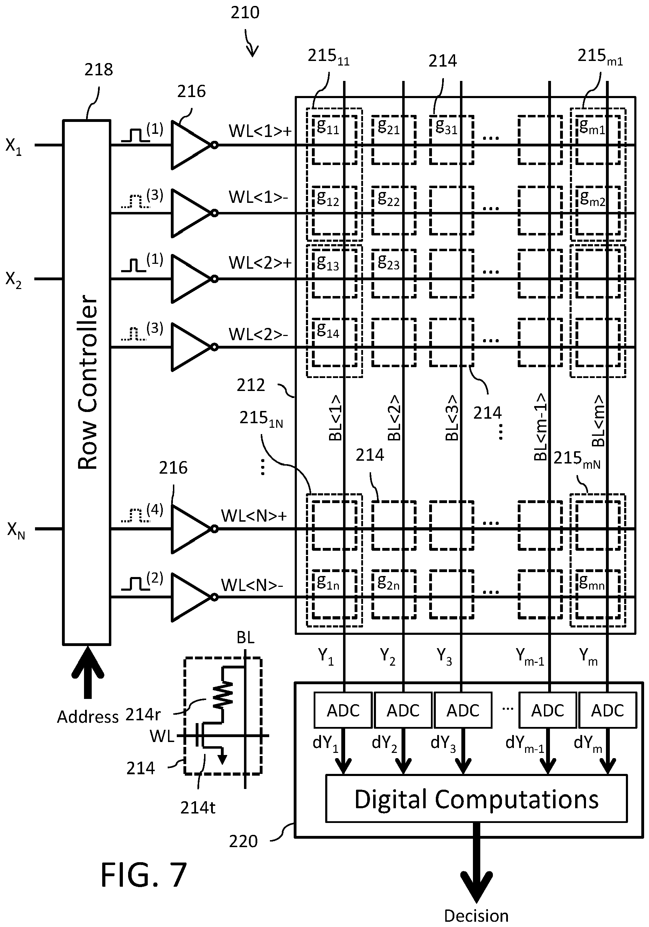

Reference is now made to Figure 7 which shows a schematic diagram of an in-memory computation circuit 210. The circuit 210 utilizes a memory array 212 formed by a plurality of memory cells 214 arranged in a matrix format having m columns and n rows. The array 212 is arranged to include groups $215_{11}$ to $215_{mN}$ of memory cells 114, wherein each group $215_{aB}$ includes two memory cells arranged in a 1x2 matrix, where a is an integer from 1 to m and B is an integer from 1 to N. With this arrangement, there are N rows of groups $215_{aB}$ and m columns of groups $215_{aB}$ (where N=n/2).

Each group $215_{aB}$ of memory cells 214 stores a signed computational weight (also referred to as kernel data) for an in-memory compute operation. Each memory cell 214 can be programmed to store a bit of data $g_{ab}$, where a is an integer from 1 to m and b is an integer from 1 to n, for the signed computational weight of the group $215_{aB}$. Each bit of data has either a logic "1" or a logic "0" value which is represented, for example, by a programmable transconductance in the memory cell 214. A signed computational weight of "+1" for a given group $215_{aB}$ is represented by programming logic "1" in an upper memory cell (for example, see $g_{11}=1$ of group $215_{11}$), and programming logic "0" in a lower memory cell (for example, see $g_{12}=0$ of group $215_{11}$) as illustrated here: $\begin{bmatrix} 1 \\ 0 \end{bmatrix}$ , also referred to in the art as a single entry matrix. A signed computational weight of "-1" for a given group $215_{aB}$ is represented by programming logic "0" in the upper memory cell (for example, see $g_{11}=0$ of group $215_{11}$), and programming logic "1" in a lower memory cell (for example, see $g_{12}=1$ of group $215_{11}$) as illustrated here: $\begin{bmatrix} 0 \\ 1 \end{bmatrix}$ , also referred to in the art as a single entry matrix. A signed computational weight of "0" for a given group $215_{aB}$ is represented by programming logic "0" in both memory cells (for example, see g i i =0, $g_{12}=0$ of group $215_{11}$) as illustrated here: $\begin{bmatrix} 0 \\ 0 \end{bmatrix}$ , also referred to in the art as a zero matrix.

In an embodiment of the memory array 212, each memory cell 214 comprises a phase change memory (PCM) cell formed by a select circuit (MOSFET transistor, BJT transistor, diode device, etc.) 214t operating as a switching element and a variable resistive element 214r providing a programmable transconductance. In the case of a MOSFET transistor for the select circuit 214t, the control node (gate) of the MOSFET transistor is connected to the word line WL. The source-drain path of the MOSFET transistor is connected in series with the variable resistive element 214r between the bit line BL and a reference node (for example, a source line or ground). More specifically, a drain of the MOSFET transistor is connected to a first terminal of the variable resistive element 214r, the source of the MOSFET transistor is connected to the reference node, and the second terminal of the variable resistive element 214r is connected to the bit line BL.

As is well known to those skilled in the art, a PCM-type memory cell 214 is configured to store data using a phase change material (such as a chalcogenide) that is capable of stably transitioning between amorphous and crystalline phases according to an amount of heat transferred thereto. The amorphous and crystalline phases exhibit two or more distinct resistances (corresponding to the variable resistive element 214r), in other words two or more distinct transconductances, which are used to distinguish two or more distinct logic states programmable into the memory cell. The amorphous phase exhibits a relatively higher resistance (i.e., a lower transconductance) and thus the current sunk from the bit line BL by the memory cell programmed in this state when selected by assertion of the word line signal at the gate of the select circuit 214t is relatively smaller. Conversely, the crystalline phase exhibits a relatively lower resistance (i.e., a higher transconductance) and thus the current sunk from the bit line BL by the memory cell programmed in this state when selected by assertion of the word line signal at the gate of the select circuit 214t is relatively larger.

In an embodiment for a specific, but non-limiting, example for two distinct logic states: the amorphous phase may represent programming of the memory cell to logic "0" (or reset state) for the associated coefficient weight and the crystalline phase may represent programming of the memory cell to logic "1" (or set state) for the associated coefficient weight.

It will be understood that other memory cell types could instead be used for the array 212. For example, magnetoresistive random access memory (MRAM) cells or resistive random access memory (RRAM) cells could be used. The memory cell may alternatively comprise a static random access memory (SRAM) cell.

Each memory cell 214 includes a word line WL and a bit line BL. The memory cells 214 in a common row of the matrix are connected to each other through a common word line WL. The groups $215_{aB}$ of memory cells 214 in a common row of groups $215_{aB}$ are connected to each other through a positive word line WL<B>+ and a negative word line WL<B>- (which form a word line pair for the common row of groups $215_{aB}$). More specifically, the positive word line WL<B>+ is connected to the upper memory cell in the 1x2 matrix for the group (for example, see WL< 1 >+ for $g_{11}$ of group 215n), while the negative word line WL<B>- is connected to the lower memory cell in the $1\times2$ matrix for the group (for example, see WL<1>- for $g_{12}$ of group 215n).

The memory cells 214 in a common column of the matrix are connected to each other through a common bit line BL. The groups $215_{aB}$ of memory cells 214 in a common column of groups $215_{aB}$ are connected to each other through a bit line BL<a>. More specifically, the bit line BL<a> is connected to the two memory cells in the $1\times2$ matrix for the group (for example, see BL<1> for $g_{11}$ and $g_{12}$ of group $215_{11}$).

Each word line WL is driven by a word line driver circuit 216 with a pulsed word line signal generated by a row controller circuit 218. The word line driver circuit 216 may be implemented as a CMOS driver circuit (for example, a series connected p-channel and n-channel MOSFET transistor pair forming a logic inverter circuit).

The row controller circuit 218 receives the signed feature or coefficient data $X_1$ to $X_N$ for the in-memory compute operation. The row controller circuit 218 also receives an address signal (Address) for the in-memory compute operation and in response thereto selectively loads the signed feature or coefficient data $X_1$ to $X_N$ for association with the rows of groups $215_{AB}$ of memory cells 214 which are to be simultaneously selected in parallel during each elaboration of the analog in-memory compute operation. During the simultaneous access for a given elaboration, only one word line of each word line pair (WL<B>+ or WL<B>-) is actuated with a pulsed word line signal The actuated one word line of the word line pair is selected based on: a) which of the first (positive) or second (negative) elaborations is being performed, and b) the logic state of the sign bit of the feature or coefficient data $X_B$. For example, consider the following cases: (1) if the first (positive) elaboration is being performed and the sign bit is logic 0, indicative of a positive coefficient data value, then the positive word line WL<B>+ is asserted; (2) if the first (positive) elaboration is being performed and the sign bit is logic 1, indicative of a negative coefficient data value, then the negative word line WL<B>- is asserted; (3) if the second (negative) elaboration is being performed and the sign bit is logic 0, indicative of a positive coefficient data value, then the negative word line WL<B>- is asserted; and (4) if the second (negative) elaboration is being performed and the sign bit is logic 1, indicative of a negative coefficient data value, then the positive word line WL<B>+ is asserted. The row controller circuit 218 still further controls, for each corresponding actuated word line, the width (i.e., the on time Torr) of the generated pulsed word line signal. This functionality is a form of a pulse width modulation (PWM) control for the applied word line signals dependent on the digital value of the received signed feature or coefficient data $X_B$.

In an embodiment, the signed feature or coefficient data $X_B$ is provided in a multi-bit signed binary format, with a 4-bit example as set forth in the following table:

| Decimal | Binary | Decimal | Binary |
|---------|--------|---------|--------|
| 0 | 0000 | 0 | 1000 |
| +1 | 0001 | -1 | 1001 |
| +2 | 0010 | -2 | 1010 |
| +3 | 0011 | -3 | 1011 |
| +4 | 0100 | -4 | 1100 |
| +5 | 0101 | -5 | 1101 |
| +6 | 0110 | -6 | 1110 |
| +7 | 0111 | -7 | 1111 |

The use of a 4-bit format for the signed feature or coefficient data $X_B$ is just an example, it being understood that the signed feature or coefficient data $X_B$ can use any selected number of bits depending on the computation application.

It will be noted that the most significant bit of the signed binary feature or coefficient data $X_B$ provides the sign bit (logic 0 is positive, logic 1 is negative) used to control selection of the positive (WL<B>+) or negative (WL<B>-) word line of the word line pair dependent on the positive/negative elaboration, while the remaining less significant bits provide the value specifying the pulse width duration for the word line signal applied to that selected word line of the word line pair during each elaboration.

Figure 7 illustrates, by way of example only, the simultaneous selection of all rows of groups $215_{aB}$ of memory cells 214 in response to non-zero coefficient data, and further illustrates, by way of example only with solid word line signal pulses (with adjacent parenthetical numbers identifying the particular case as noted above), the positive elaboration of the in-memory compute operation including the simultaneous actuation of certain positive word lines (WL<1>+ and WL<2>+, for example) corresponding to positively signed feature or coefficient data ($X_1$ and $X_2$, for example) with pulsed word line signals having pulse widths set by the digital value of the corresponding coefficient data (case (1)), along with the simultaneous actuation of certain negative word lines (WL<N>-, for example) corresponding to negatively signed feature or coefficient data ($X_N$, for example) with pulsed word line signals having pulse widths set by the digital value of the corresponding coefficient data (case (2)).

Figure 7 further illustrates, by way of example only, the simultaneous selection of all rows of groups $215_{aB}$ of memory cells 214 in response to non-zero coefficient data, and further illustrates, by way of example only with dotted word line signal pulses (with adjacent parenthetical numbers identifying the particular case as noted above), the negative elaboration of the in-memory compute operation including the simultaneous actuation of certain negative word lines (WL<1>- and WL<2>-, for example) corresponding to positively signed feature or coefficient data ($X_1$ and $X_2$, for example) with pulsed word line signals having pulse widths set by the digital value of the corresponding coefficient data (case (3)), along with the simultaneous actuation of certain positive word lines (WL<N>+, for example) corresponding to negatively signed feature or coefficient data ($X_N$, for example) with pulsed word line signals having pulse widths set by the digital value of the corresponding coefficient data (case (4)).

It will, of course, be understood that the positive/negative elaborations for the analog in-memory compute operation may instead utilize a simultaneous selection of fewer than all rows of groups $215_{aB}$ of memory cells 214 (through either Address signal selection or through a zero value for the coefficient data $X_B$).

The analog signal $Y_a$ developed during the elaboration on each bit line BL<a> is dependent on the logic state of the bit of data $g_{ab}$ for the signed computational weight stored in the memory cells 214 of the column and the widths of the pulsed word line signals applied to the word lines WL for those memory cells 214. More specifically, it will be understood that each memory cell 214 contributes a bit line BL discharge current during the elaboration that is proportional to $X_B \times g_{ab}$. So, in the example shown in Figure 7 where the (solid) word line signals are simultaneously applied to the word lines WL<1>+, WL<2>+, ..., WL<N>- during the first (positive) elaboration of the in-memory compute operation, the analog signal Yi developed on the bit line BL<1> is proportional to the sum of discharge currents due to $X_1 \times g_{11}$, $0 \times g_{12}, X_2 \times g_{13}, 0 \times g_{14}, ..., 0 \times g_{1n-1}$ and $X_N \times g_{1n}$. Conversely, where the (dotted) word line signals are simultaneously applied to the word lines WL<1>-, WL<2>-, ..., WL<N>+ during the second (negative) elaboration, the analog signal Yi developed on the same bit line BL<1> is proportional to the sum of discharge currents due to $0 \times g_{11}$, $X_1 \times g_{12}$, $0 \times g_{13}$, $X_2 \times g_{14}, ..., X_N \times g_{1n-1}$ and $0 \times g_{1n}$. The overall result of the in-memory compute operation is a function of the difference between analog signals developed during the first and second elaborations.

Let's assume now, for example only, some specific signed computational weights for the groups $215_{aB}$ of memory cells 214 in this column of groups. Group $215_{11}$ is programmed with weight of -1 which is represented by $\begin{bmatrix} 0 \\ 1 \end{bmatrix}$. Group $115_{12}$ is programmed with weight of 0 which is represented by $\begin{bmatrix} 0 \\ 0 \end{bmatrix}$. Group $115_{1N}$ is programmed with weight of +1 which is represented by $\begin{bmatrix} 1 \\ 0 \end{bmatrix}$. So, for this example, the analog signal Yi developed on the bit line BL< 1 > during the first (positive) elaboration is proportional to the sum of discharge currents due to $X_1 \times 0$, $0 \times 1$, $X_2 \times 0$, $0 \times 0$, ..., $0 \times 1$ and $X_N \times 0$; which would result in zero discharge currents on the bit line BL<1>. The analog signal Yi developed on the bit line BL<1> during the second (negative) elaboration is proportional to the sum of discharge currents due to $0 \times 0$, $X_1 \times 1$, $0 \times 0$, $X_2 \times 0$, ..., $X_N \times 1$ and $0 \times 0$; which results in a sum of discharge currents due to $X_1 \times 1$, ..., and $X_N \times 1$ on the bit line BL<1>.

A column processing circuit 220 senses and samples during each of the first and second elaborations of the in-memory compute operation the analog signal $Y_a$ on each bit line BL<a> for the m columns and converts the analog signal to a corresponding digital signal $dY_a$ using analog-to-digital converter circuitry. Although Figure 7 illustrates that one analog-to-digital converter (ADC) is provided for each column, it will be understood that ADC resources in the column processing circuit 220 could instead be shared by multiple columns using time division multiplexing. The column processing circuit 220 further includes digital signal processing circuitry for storing the resulting digital signals $dY_a$ for the two elaborations and performing digital computations and calculations on the digital signals $dY_a$ to generate a decision output for the in-memory compute operation. The further computations and calculations performed may include subtracting the digital signal $dY_A$ for the negative elaboration from the digital signal $dY_A$ for the positive elaboration.

Although not explicitly shown in Figure 7, it will be understood that the circuit 210 further includes conventional row decode, column decode, and read-write circuits known to those skilled in the art for use in connection with writing bits of data (for example, the computational weight data) to, and reading bits of data from, the memory cells 214 of the memory array 212. This operation is referred to as a conventional memory access mode and is distinguished from the analog in-memory compute operation discussed above.

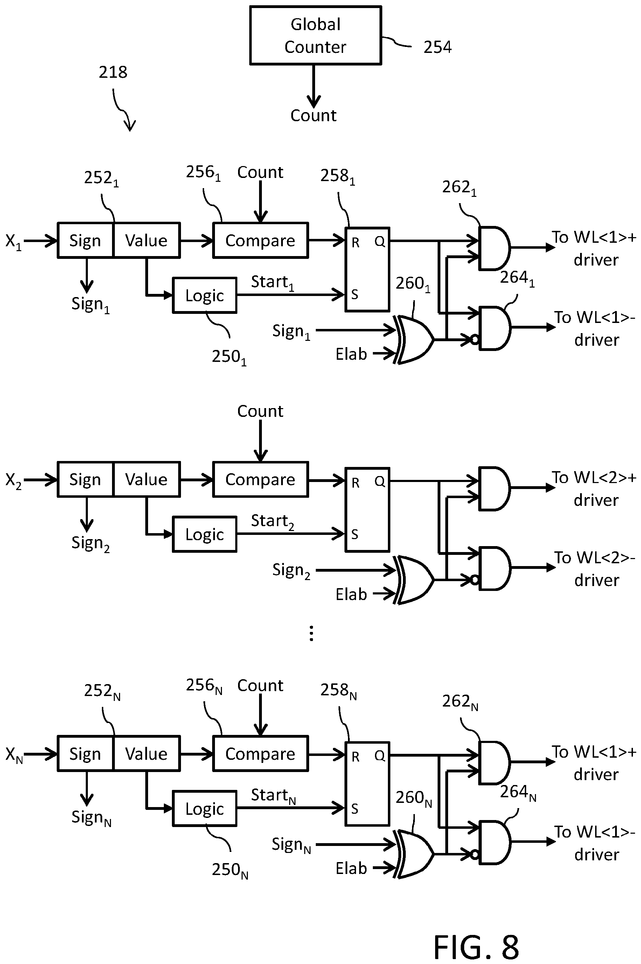

*Reference is now made to Figure 8 which shows a circuit diagram for the row controller 218. A latch circuit $252_B$ is provided for each row of groups $215_{aB}$ of memory cells 214 to latch the corresponding sign and value of the signed digital value of the coefficient data $X_B$. A logic circuit $250_B$ is provided for each row of groups $215_{aB}$ of memory cells 214. The logic circuits $250_1$ to $250_N$ assert a start signal ($Start_B$), for example in response to a global start signal, at a beginning of each elaboration of the first (positive) and second (negative) elaborations of the in-memory compute operation. The generation of this start signal may, for example, be dependent on the corresponding signed digital value of the coefficient data $X_B$ having a non-zero value for the analog in-memory compute operation. A global counter circuit 254 increments a count value (Count) starting from a zero reset at the beginning of each elaboration for the in-memory compute operation, wherein the elaboration ends when the Count reached a maximum value. A compare circuit $256_B$ for each row of groups $215_{aB}$ of memory cells 214 is coupled to the latch circuit $252_B$ and compares the count value Count to the latched digital value of the coefficient data $X_B$. The output of the compare circuit $256_B$ is asserted when the count value Count meets or exceeds the latched digital value. A set-reset latch circuit $258_B$ has a set (S) input coupled to receive the $Start_B$ signal output from the logic circuit $250_B$ and a reset (R) input coupled to receive the output of the compare circuit $256_B$. A combinational logic circuit $260_B$ logically combines the sign bit $Sign_B$ from the latch circuit $252_B$ and an elaboration indicator signal (Elab). The toggling logic state of the elaboration indicator signal Elab indicates whether the first (positive) elaboration is being performed (logic 1) or the second (negative) elaboration is being performed (logic 0). In an embodiment, the combinational logic circuit $260_B$ is a logic exclusive OR (XOR) gate. A combinational logic circuit $262_B$ logically combines the output (Q) of the set-reset latch circuit $258_B$ and the output of the combinational logic circuit $260_B$ to generate the pulsed word line signal for application to the driver circuit 216 of the positive word line WL<B>+. A combinational logic circuit $264_B$ logically combines the output (Q) of the set-reset latch circuit $258_B$ and the logical inverse of the output of the combinational logic circuit $260_B$ to generate the pulsed word line signal for application to the driver circuit 216 of the negative word line WL<B>-. In an embodiment, the combinational logic circuits $262_B$ and $264_B$ are logic AND gates.

Operation of the circuitry within the row controller 218 is as follows: At the beginning of the in-memory compute operation, decoding of the address signal Address is used to selectively load the digital values of the coefficient data $X_1$ to $X_N$ to be latched by the latch circuits $252_1$ to $252_N$, and the global counter 254 is reset. If the coefficient data is non-zero, there is a selection of the row of groups $215_{aB}$ of memory cells 214, and the start signal $Start_B$ output of the logic circuit $250_B$ is asserted logic high at the beginning of each elaboration of the first (positive) and second (negative) elaborations, and the set-reset latch circuit $258_B$ is set with its output Q logic high. The logic state of the toggling elaboration indicator signal Elab indicates whether the first (positive) elaboration is being performed (logic 1) or the second (negative) elaboration is being performed (logic 0). Consideration is now made to each of the four cases noted above. Case (1): if the sign bit $Sign_B$ is logic 0, indicating that the digital value of the coefficient data $X_B$ is positive, and the elaboration indicator signal Elab is logic 1, indicating the first (positive) elaboration of the in-memory compute operation is being performed, the inputs of the XOR gate $260_B$ are opposite logic and the output of the XOR gate $260_B$ is logic high. Here, both inputs of the AND gate $262_B$ are logic high and the output of the AND gate $262_B$ transitions to logic high to provide the leading edge of the word line signal pulse on the positive word line WL<B>+. Case (2): if the sign bit $Sign_B$ is logic 1, indicating that the digital value of the coefficient data $X_B$ is negative, and the elaboration indicator signal Elab is logic 1, indicating the first (positive) elaboration of the in-memory compute operation is being performed, both inputs of the XOR gate $260_B$ are logic high and the output of the XOR gate $260_B$ is logic low. Here, both inputs of the AND gate $264_B$ are logic high and the output of the AND gate $264_B$ transitions to logic high to provide the leading edge of the word line signal pulse on the negative word line WL<B>-. Case (3): if the sign bit $Sign_B$ is logic 0, indicating that the digital value of the coefficient data $X_B$ is positive, and the elaboration indicator signal Elab is logic 0, indicating the second (negative) elaboration of the in-memory compute operation is being performed, both inputs of the XOR gate $260_B$ are logic low and the output of the XOR gate $260_B$ is logic low. Here, both inputs of the AND gate $264_B$ are logic high and the output of the AND gate $264_B$ transitions to logic high to provide the leading edge of the word line signal pulse on the negative word line WL<B>-. Case (4): if the sign bit $Sign_B$ is logic 1, indicating that the digital value of the coefficient data $X_B$ is negative, and the elaboration indicator signal Elab is logic 0, indicating the second (negative) elaboration of the in-memory compute operation is being performed, the inputs of the XOR gate $260_B$ are opposite logic and the output of the XOR gate $260_B$ is logic high. Here, both inputs of the AND gate $262_B$ are logic high and the output of the AND gate $262_B$ transitions to logic high to provide the leading edge of the word line signal pulse on the positive word line WL<B>+. The global counter 254 then begins incrementing the Count value. When the incrementing Count value meets or exceeds the digital value of the coefficient data $X_B$ latched by the latch circuit $252_B$, the output of the compare circuit $256_B$ is asserted logic high, and the set-reset latch circuit $258_B$ is reset with its output Q logic low. This logic low output is applied to both AND gates $262_B$ and $264_B$, and whichever output of those AND gates is logic high (corresponding to assertion of the word line signal pulse) will transition to logic low to provide the trailing edge of the word line signal pulse. The pulse width (i.e., the on time Torr) of the generated pulsed word line signal is thus dependent on the amount of time needed for the incrementing Count value to reach the digital value of the coefficient data $X_B$. When the Count reaches its maximum value, the given elaboration ends.

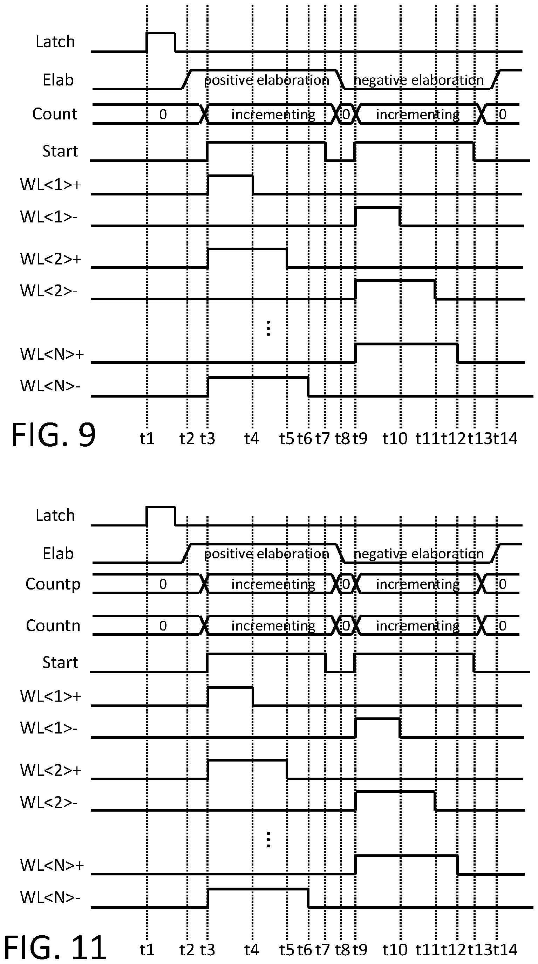

Reference is now made to Figure 9 which shows a simplified timing diagram for operation of the circuit 210 in connection with one overall in-memory compute operation including two separate elaborations and use of the circuit 218. At time t1, a latch control signal is asserted to cause the latch circuits $252_1$ to $252_N$ to latch the signed digital values of the coefficient data $X_1$ to $X_N$, and the overall in-memory compute operation begins. At time t2, the elaboration indicator signal Elab toggles to logic 1 in connection with starting the first (positive) elaboration of the in-memory compute operation. We assume here the example discussed above and shown in Figure 7 where, during the first (positive) elaboration of the in-memory compute operation, there is a simultaneous selection of all rows of groups $215_{aB}$ of memory cells 214 in response to the non-zero coefficient data, and the simultaneous actuation in response to assertion of the $Start_B$ signals at time t3 of the word lines WL<1>+, WL<2>+ corresponding to the positive feature or coefficient data $X_1$, $X_2$ with pulsed word line signals (case (1)) and also the word line WL<N>- corresponding to the negative feature or coefficient data $X_N$ with a pulsed word line signal (case (2)). Also at time t3, the previously reset Count value begins to increment. At time t4, the incrementing Count value meets or exceeds the digital value of the coefficient data $X_1$, and the word line signal pulse on the positive word line WL<1>+ terminates. At time t5, the incrementing Count value meets or exceeds the digital value of the coefficient data $X_2$, and the word line signal pulse on the positive word line WL<2>+ terminates. At time t6, the incrementing Count value meets or exceeds the digital value of the coefficient data $X_N$, and the word line signal pulse on the negative word line WL<N>-terminates. At time t7, the Start signal is deasserted and the Count value is reset. Additionally, the analog signals $Y_1$ to $Y_m$ on the bit lines BL< 1 > to BL<m> are sampled for analog-to-digital conversion. At time t8, the elaboration indicator signal Elab toggles to logic 0 in connection with ending the first (positive) elaboration of the in-memory compute operation.

The toggling of the elaboration indicator signal Elab to logic 0 at time t8 additionally starts the second (negative) elaboration of the in-memory compute operation. We assume here the example discussed above and shown in Figure 7 where, during the second (negative) elaboration of the in-memory compute operation, there is a simultaneous selection of all rows of groups $215_{aB}$ of memory cells 214 in response to the non-zero coefficient data, and the simultaneous actuation in response to assertion of the $Start_B$ signals at time t9 of the word lines WL<1>-, WL<2>- corresponding to the positive feature or coefficient data $X_1$, $X_2$ with pulsed word line signals (case (3)) and also the word line WL<N>+ corresponding to the negative feature or coefficient data $X_N$ with a pulsed word line signal (case (4)). Also at time t9, the previously reset Count value begins to increment. At time t10, the incrementing Count value meets or exceeds the digital value of the coefficient data $X_1$, and the word line signal pulse on the negative word line WL<1>- terminates. At time t11, the incrementing Count value meets or exceeds the digital value of the coefficient data $X_2$, and the word line signal pulse on the negative word line WL<2>- terminates. At time t12, the incrementing Count value meets or exceeds the digital value of the coefficient data $X_N$, and the word line signal pulse on the positive word line WL<N>+ terminates. At time t13, the Start signal is deasserted and the Count value is reset. Additionally, the analog signals $Y_1$ to $Y_m$ on the bit lines BL<1> to BL<m> are sampled for analog-to-digital conversion. At time t14, the elaboration indicator signal Elab toggles to logic 1 in connection with both ending the second (negative) elaboration of the in-memory compute operation and ending the overall in-memory compute operation.

An advantage of the Figure 7 implementation is that the signed computational weight for the in-memory compute operation is coded on two memory cells 214 forming the group $215_{aB}$ with a 1x2 matrix configuration, while the Figure 4 implementation utilizes four memory cells 114 forming the group $115_{AB}$ with a 2x2 matrix configuration. There is accordingly a 2x memory reduction for the array 212 compared to the array 112 (or there is a 2x increase in weight storage capacity for the array 212 compared to the array 112).

A drawback of the circuit implementation for the row controller 218 shown in Figure 8 is that it cannot handle signed computational weight in a 2's complement binary format. For example, the signed feature or coefficient data $X_B$ may be provided in a multi-bit 2's complement binary format, with 4-bits by example as set forth in the following table:

| Decimal | Binary | Decimal | Binary |
|---|---|---|---|
| 0 | 0000 | -8 | 1000 |
| +1 | 0001 | -7 | 1001 |
| +2 | 0010 | -6 | 1010 |
| +3 | 0011 | -5 | 1011 |
| +4 | 0100 | -4 | 1100 |
| +5 | 0101 | -3 | 1101 |
| +6 | 0110 | -2 | 1110 |

(continued)

| Decimal | Binary | Decimal | Binary |
|---------|--------|---------|--------|
| +7 | 0111 | -1 | 1111 |

The use of a 4-bit format for the signed feature or coefficient data $X_B$ is just an example, it being understood that the signed feature or coefficient data $X_B$ can use any selected number of bits depending on the computation application.

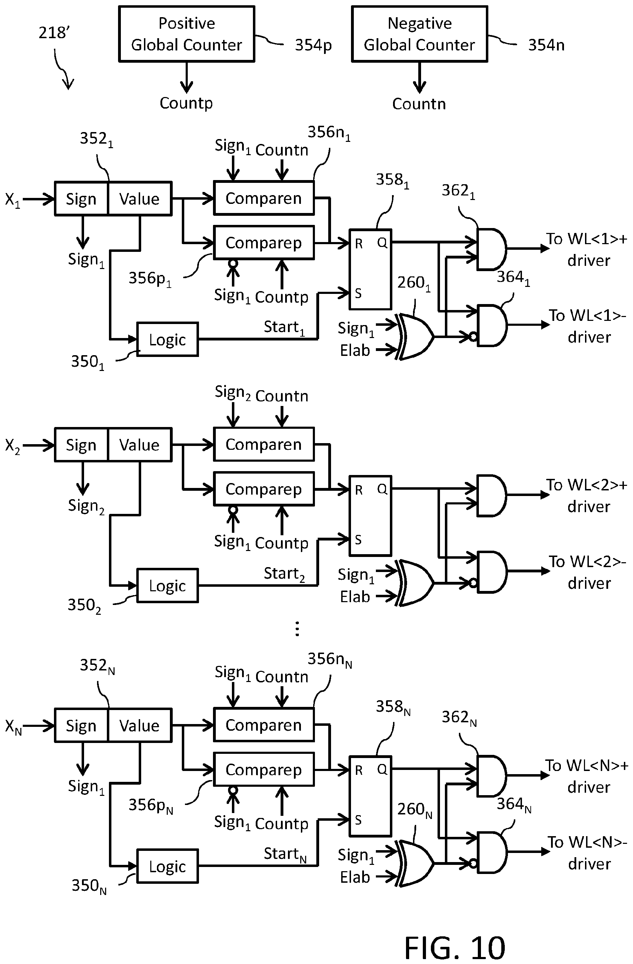

It will be noted that the most significant bit of the 2's complement binary signed feature or coefficient data $X_B$ provides the sign bit (logic 0 is positive, logic 1 is negative) used to control selection of the positive (WL<B>+) or negative (WL<B>-) word line of the word line pair dependent on the positive/negative elaboration, while the remaining less significant bits provide the value specifying the pulse width duration for the word line signal applied to that selected word line of the word line pair during each elaboration. However, because the range of positive values (0 to +7) is different from the range of negative values (0 to -8), the circuit implementation for the row controller 218 shown in Figure 8 will not work. An alternative circuit implementation for the row controller 218' supporting 2's complement binary signed feature or coefficient data $X_B$ is shown in Figure 10.

A latch circuit $352_B$ is provided for each row of groups $215_{aB}$ of memory cells 214 to latch the corresponding sign and value of the signed digital value of the coefficient data $X_B$. A logic circuit $350_B$ is provided for each row of groups $215_{aB}$ of memory cells 214. The logic circuits $350_1$ to $350_N$ assert a start signal (Start$_B$) at a beginning of each elaboration of the first (positive) and second (negative) elaborations of the in-memory compute operation. The generation of this start signal may, for example, be dependent on the corresponding signed digital value of the coefficient data $X_B$ having a non-zero value for the analog in-memory compute operation. A positive global counter circuit 354p increments a positive count value (Count0) starting from a zero reset at the beginning of each elaboration for the in-memory compute operation. A negative global counter circuit 354n increments a negative count value (Countn) starting from a zero reset at the beginning of each elaboration for the in-memory compute operation. The elaboration ends when the Countn reaches a maximum value. A positive compare circuit $356p_B$ for each row of groups $215_{aB}$ of memory cells 214 is coupled to the latch circuit $352_B$. The positive compare circuit $356p_B$ is enabled in response to a logic low state of the sign bit Sign$_B$ (indicating that the signed digital value of the coefficient data $X_B$ is positive) and compares the positive count value Countp to the latched digital value of the coefficient data $X_B$. A negative compare circuit $356n_B$ for each row of groups $215_{aB}$ of memory cells 214 is coupled to the latch circuit $352_B$. The negative compare circuit $236n_B$ is enabled in response to a logic high state of the sign bit Sign$_B$ (indicating that the signed digital value of the coefficient data $X_B$ is negative) and compares the negative count value Countn to the latched digital value of the coefficient data $X_B$. The signal output from the enabled one of compare circuits $356p_B$ and $356n_B$ is asserted when the count value Countp or Countn meets or exceeds the latched digital value. A set-reset latch circuit $358_B$ has a set (S) input coupled to receive the Start$_B$ signal output from the logic circuit $350_B$ and a reset (R) input coupled to receive the output of the enabled one of the compare circuits $356p_B$ or $356n_B$. A combinational logic circuit $360_B$ logically combines the sign bit Sign$_B$ from the latch circuit $352_B$ and an elaboration indicator signal (Elab). The toggling logic state of the elaboration indicator signal Elab indicates whether the first (positive) elaboration is being performed (logic 1) or the second (negative) elaboration is being performed (logic 0). In an embodiment, the combinational logic circuit $360_B$ is a logic exclusive OR (XOR) gate. A combinational logic circuit $362_B$ logically combines the output (Q) of the set-reset latch circuit $358_B$ and the output of the combinational logic circuit $360_B$ to generate the pulsed word line signal for application to the driver circuit 216 of the positive word line WL<B>+. A combinational logic circuit $364_B$ logically combines the output (Q) of the set-reset latch circuit $358_B$ and the logical inverse of the output of the combinational logic circuit $360_B$ to generate the pulsed word line signal for application to the driver circuit 216 of the negative word line WL<B>-. In an embodiment, the combinational logic circuits $362_B$ and $364_B$ are logic AND gates.

Operation of the circuitry within the row controller 218' is as follows: At the beginning of the in-memory compute operation, decoding of the address signal Address is used to selectively load the digital values of the coefficient data $X_1$ to $X_N$ to be latched by the latch circuits $352_1$ to $352_N$, and the global counters 354p and 354n are reset. If the coefficient data is non-zero, there is a selection of the row of groups $215_{aB}$ of memory cells 214, and the start signal Start$_B$ output of the logic circuit $350_B$ is asserted logic high at the beginning of each elaboration of the first (positive) and second (negative) elaborations, and the set-reset latch circuit $358_B$ is set with its output Q logic high. The logic state of the toggling the elaboration indicator signal Elab indicates whether the first (positive) elaboration is being performed (logic 1) or the second (negative) elaboration is being performed (logic 0). Consideration is now made to each of the four cases noted above. Case (1): if the sign bit Sign$_B$ is logic 0, indicating that the digital value of the coefficient data $X_B$ is positive, and the elaboration indicator signal Elab is logic 1, indicating the first (positive) elaboration of the in-memory compute operation is being performed, the positive compare circuit $356p_B$ is enabled and the inputs of the XOR gate $360_B$ are opposite logic and the output of the XOR gate $360_B$ is logic high. Here, both inputs of the AND gate $362_B$ are logic high and the output of the AND gate $362_B$ transitions to logic high to provide the leading edge of the word line signal pulse on the positive word line WL<B>+. Case (2): if the sign bit $Sign_B$ is logic 1, indicating that the digital value of the coefficient data $X_B$ is negative, and the elaboration indicator signal Elab is logic 1, indicating the first (positive) elaboration of the in-memory compute operation is being performed, the negative compare circuit $356n_B$ is enabled and both inputs of the XOR gate $360_B$ are logic high and the output of the XOR gate $360_B$ is logic low. Here, both inputs of the AND gate $364_B$ are logic high and the output of the AND gate $364_B$ transitions to logic high to provide the leading edge of the word line signal pulse on the negative word line WL<B>-. Case (3): if the sign bit $Sign_B$ is logic 0, indicating that the digital value of the coefficient data $X_B$ is positive, and the elaboration indicator signal Elab is logic 0, indicating the second (negative) elaboration of the in-memory compute operation is being performed, the positive compare circuit $356p_B$ is enabled and both inputs of the XOR gate $360_B$ are logic low and the output of the XOR gate $360_B$ is logic low. Here, both inputs of the AND gate $364_B$ are logic high and the output of the AND gate $364_B$ transitions to logic high to provide the leading edge of the word line signal pulse on the negative word line WL<B>-. Case (4): if the sign bit $Sign_B$ is logic 1, indicating that the digital value of the coefficient data $X_B$ is negative, and the elaboration indicator signal Elab is logic 0, indicating the second (negative) elaboration of the in-memory compute operation is being performed, the negative compare circuit $356n_B$ is enabled and the inputs of the XOR gate $360_B$ are opposite logic and the output of the XOR gate $360_B$ is logic high. Here, both inputs of the AND gate $362_B$ are logic high and the output of the AND gate $362_B$ transitions to logic high to provide the leading edge of the word line signal pulse on the positive word line WL<B>+. The global counters 354p and 354n then begin incrementing the Countp and Countn values. For cases (1) and (3) where the positive compare circuit $356p_B$ is enabled by the logic low sign bit $Sign_B$, when the incrementing Countp value meets or exceeds the digital value of the coefficient data $X_B$ latched by the latch circuit $352_B$, the output of the compare circuit $356_B$ is asserted logic high, and the set-reset latch circuit $358_B$ is reset with its output Q logic low. This logic low output is applied to both AND gates $362_B$ and $364_B$, and whichever output of those AND gates is logic high (corresponding to assertion of the word line signal pulse) will transition to logic low to provide the trailing edge of the word line signal pulse. The pulse width (i.e., the on time Torr) of the generated pulsed word line signal is thus dependent on the amount of time needed for the incrementing Countp value to reach the digital value of the coefficient data $X_B$. For cases (2) and (4) where the negative compare circuit $356n_B$ is enabled by the logic high sign bit $Sign_B$, when the incrementing Countn value meets or exceeds the digital value of the coefficient data $X_B$ latched by the latch circuit $352_B$, the output of the compare circuit $356_B$ is asserted logic high, and the set-reset latch circuit $358_B$ is reset with its output Q logic low. This logic low output is applied to both AND gates $362_B$ and $364_B$, and whichever output of those AND gates is logic high (corresponding to assertion of the word line signal pulse) will transition to logic low to provide the trailing edge of the word line signal pulse. The pulse width (i.e., the on time Torr) of the generated pulsed word line signal is thus dependent on the amount of time needed for the incrementing Countn value to reach the digital value of the coefficient data $X_B$. When the Countn reaches its maximum value, the given elaboration ends.

Reference is now made to Figure 11 which shows a simplified timing diagram for operation of the circuit 210 in connection with one overall in-memory compute operation including two separate elaborations and the use of the circuit 281'. At time t1, a latch control signal is asserted to cause the latch circuits $352_1$ to $352_N$ to latch the signed digital values of the coefficient data $X_1$ to $X_N$, and the overall in-memory compute operation begins. At time t2, the elaboration indicator signal Elab toggles to logic 1 in connection with starting the first (positive) elaboration of the in-memory compute operation. We assume here the example discussed above and shown in Figure 7 where, during the first (positive) elaboration of the in-memory compute operation, there is a simultaneous selection of all rows of groups $215_{aB}$ of memory cells 214 in response to the non-zero coefficient data, and the simultaneous actuation in response to assertion of the $Start_B$ signals at time t3 of the word lines WL<1>+, WL<2>+ corresponding to the positive feature or coefficient data $X_1$, $X_2$ with pulsed word line signals (case (1)) and also the word line WL<N>- corresponding to the negative feature or coefficient data $X_N$ with a pulsed word line signal (case (2)). Also at time t3, the previously reset Countp and Countn values begin to increment. At time t4, the incrementing Countp value meets or exceeds the digital value of the coefficient data $X_1$, and the word line signal pulse on the positive word line WL<1>+ terminates. At time t5, the incrementing Countp value meets or exceeds the digital value of the coefficient data $X_2$, and the word line signal pulse on the positive word line WL<2>+ terminates. At time t6, the incrementing Countn value meets or exceeds the digital value of the coefficient data $X_N$, and the word line signal pulse on the negative word line WL<N>- terminates. At time t7, the Start signal is deasserted and the Countp and Countn values are reset. Additionally, the analog signals Yi to $Y_m$ on the bit lines BL<1> to BL<m> are sampled for analog-to-digital conversion. At time t8, the elaboration indicator signal Elab toggles to logic 0 in connection with ending the first (positive) elaboration of the in-memory compute operation.

The toggling of the elaboration indicator signal Elab to logic 0 at time t8 additionally starts the second (negative) elaboration of the in-memory compute operation. We assume here the example discussed above and shown in Figure 7 where, during the second (negative) elaboration of the in-memory compute operation, there is a simultaneous selection of all rows of groups $215_{aB}$ of memory cells 214 in response to the non-zero coefficient data, and the simultaneous actuation in response to assertion of the $Start_B$ signals at time t9 of the word lines WL<1>-, WL<2>- corresponding to the positive feature or coefficient data $X_1$, $X_2$ with pulsed word line signals (case (3)) and also the word line WL<N>+

corresponding to the negative feature or coefficient data $X_N$ with a pulsed word line signal (case (4)). Also at time t9, the previously reset Countp and Countn values begin to increment. At time t10, the incrementing Countp value meets or exceeds the digital value of the coefficient data $X_1$, and the word line signal pulse on the negative word line WL<1>- terminates. At time t11, the incrementing Countp value meets or exceeds the digital value of the coefficient data $X_2$, and the word line signal pulse on the negative word line WL<2>- terminates. At time t12, the incrementing Countn value meets or exceeds the digital value of the coefficient data $X_N$, and the word line signal pulse on the positive word line WL<N>+ terminates. At time t13, the Start signal is deasserted and the Countp and Countn values are reset. Additionally, the analog signals $Y_1$ to $Y_m$ on the bit lines BL< 1> to BL<m> are sampled for analog-to-digital conversion. At time t14, the elaboration indicator signal Elab toggles to logic 1 in connection with both ending the second (negative) elaboration of the in-memory compute operation and ending the overall in-memory compute operation.

Finally, it is clear that modifications and variations may be made to the in-memory computation circuit described and illustrated herein without thereby departing from the scope of the present invention, as defined in the attached claims.

For example, embodiments of the present disclosure comprise:

Example 1. An in-memory computation circuit, comprising:

a memory array including a plurality of memory cells arranged in a matrix with plural rows and plural columns, wherein groups of memory cells store computational weights for an in-memory compute (IMC) operation that is performed with a first multiply and accumulate (MAC) elaboration and a second MAC elaboration, each row of groups of memory cells including a positive word line coupled to a first memory cell in each group of memory cells and a negative word line coupled to a second memory cell in each group of memory cells, and each column of groups of memory cells including a bit line coupled to the first and second memory cells of each group of memory cells;

a row controller circuit configured to receive signed coefficient data for the IMC operation and: a) generate during the first MAC elaboration a pulsed word line signal for application to the positive word line when the signed coefficient data is positive, and generate a pulsed word line signal for application to the negative word line when the signed coefficient data is negative; and b) generate during the second MAC elaboration a pulsed word line signal for application to the negative word line when the signed coefficient data is positive, and generate a pulsed word line signal for application to the positive word line when the signed coefficient data is negative; and

a column processing circuit coupled to the bit line and configured to: a) sense a first analog signal developed on the bit line during the first MAC elaboration; and b) sense a second signal developed on the bit line during the second MAC elaboration.

Example 2. The in-memory computation circuit of Example 1, wherein the column processing circuit is further configured to process the first and second analog signals to generate a result of the IMC operation.

Example 3. The in-memory computation circuit of Example 2, wherein the processing of the first and second analog signals to generate the result of the IMC operation comprises determining a difference between the first and second analog signals.

Example 4. The in-memory computation circuit of Example 1, wherein the row controller circuit is further configured to identify a plurality of rows of groups of memory cells to be simultaneously selected for receiving pulsed word line signals during the first and second MAC elaborations of the IMC operation.

Example 5. The in-memory computation circuit of Example 1, wherein the signed coefficient data for the IMC operation is in a signed binary format including a sign bit and a plurality of data bits providing a coefficient value, and wherein the row controller circuit is further configured to control a pulse width of the pulsed word line signal dependent on the coefficient value.

Example 6. The in-memory computation circuit of Example 5, wherein the row controller circuit comprises, for each row of groups of memory cells:

a data latch configured to latch the sign bit and plurality of data bits for the signed coefficient data;

a counter circuit configured to generate an incrementing count value; and

a comparison circuit configured to compare the coefficient value specified by the latched plurality of data bits to the incrementing count value and control a trailing edge of the pulse width of the pulsed word line signal based on the comparison.

Example 7. The in-memory computation circuit of Example 5, wherein the row controller circuit comprises, for each row of groups of memory cells:

a data latch configured to latch the sign bit and plurality of data bits for the signed coefficient data;

logic circuitry having a first input coupled to receive the sign bit, a second input coupled to receive an elaboration indication signal having a first logic state during the first MAC elaboration and having a second logic state during the second MAC elaboration, and an output configured to generate a control signal for selecting one of the positive and negative word lines for application of the pulsed word line signal.

Example 8. The in-memory computation circuit of Example 7, further including:

a first logic gate having a first input coupled to receive the control signal, a second input configured to receive the pulsed word line signal, and an output coupled to the positive word line; and
a second logic gate having a first input coupled to receive a logical inverse of the control signal, a second input configured to receive the pulsed word line signal, and an output coupled to the negative word line.

Example 9. The in-memory computation circuit of Example 8, further including a set-reset flip flop configured to generate the pulsed word line signal.

Example 10. The in-memory computation circuit of Example 9, wherein a first state of the set-reset flip flop is controlled by a start of each of the first and second MAC elaborations and a second state of the set-reset flip flop is controlled by a timing circuit

Example 11. The in-memory computation circuit of Example 10, wherein the timing circuit comprises:

a counter circuit configured to generate an incrementing count value; and
a comparison circuit configured to compare the coefficient value specified by the latched plurality of data bits to the incrementing count value and generate a signal controlling the second state based on the comparison.

Example 12. The in-memory computation circuit of Example 1, wherein the signed coefficient data for the IMC operation is in a signed 2's complement format including a sign bit and a plurality of data bits providing a coefficient value, and wherein the row controller circuit is further configured to control a pulse width of the pulsed word line signal dependent on the coefficient value.

Example 13. The in-memory computation circuit of Example 12, wherein the row controller circuit comprises, for each row of groups of memory cells:

a data latch configured to latch the sign bit and plurality of data bits for the signed coefficient data;
a first counter circuit configured to generate a first incrementing count value;
a second counter circuit configured to generate a second incrementing count value;
a first comparison circuit enabled by a first logic state of the sign bit to compare the coefficient value specified by the latched plurality of data bits to the first incrementing count value and control a trailing edge of the pulse width of the pulsed word line signal based on the first comparison; and
a second comparison circuit enabled by a second logic state of the sign bit to compare the coefficient value specified by the latched plurality of data bits to the second incrementing count value and control the trailing edge of the pulse width of the pulsed word line signal based on the second comparison.

Example 14. The in-memory computation circuit of Example 12, wherein the row controller circuit comprises, for each row of groups of memory cells:

a data latch configured to latch the sign bit and plurality of data bits for the signed coefficient data;
logic circuitry having a first input coupled to receive the sign bit, a second input coupled to receive an elaboration indication signal having a first logic state during the first MAC elaboration and having a second logic state during the second MAC elaboration, and an output configured to generate a control signal for selecting one of the positive and negative word lines for application of the pulsed word line signal.

Example 15. The in-memory computation circuit of Example 14, further including:

a first logic gate having a first input coupled to receive the control signal, a second input configured to receive the pulsed word line signal, and an output coupled to the positive word line; and
a second logic gate having a first input coupled to receive a logical inverse of the control signal, a second input configured to receive the pulsed word line signal, and an output coupled to the negative word line.

Example 16. The in-memory computation circuit of Example 15, further including a set-reset flip flop configured to generate the pulsed word line signal.

Example 17. The in-memory computation circuit of Example 16, wherein a first state of the set-reset flip flop is controlled by a start of each of the first and second MAC elaborations and a second state of the set-reset flip flop is controlled by a timing circuit.

Example 18. The in-memory computation circuit of Example 17, wherein the timing circuit comprises:

a first counter circuit configured to generate a first incrementing count value;

a second counter circuit configured to generate a second incrementing count value;

a first comparison circuit enabled by a first logic state of the sign bit to compare the coefficient value specified by the latched plurality of data bits to the first incrementing count value and generate a signal controlling the second state based on the first comparison; and

a second comparison circuit enabled by a second logic state of the sign bit to compare the coefficient value specified by the latched plurality of data bits to the second incrementing count value and generate the signal controlling the second state based on the second comparison.

Example 19. An in-memory computation circuit, comprising:

a memory array including a plurality of memory cells arranged in a matrix with plural rows and plural columns, wherein groups of memory cells store computational weights for an in-memory compute (IMC) operation that is performed with a first multiply and accumulate (MAC) elaboration and a second MAC elaboration, each row of groups of memory cells including a positive word line coupled to first and second memory cells in each group of memory cells and a negative word line coupled to third and fourth memory cells in each group of memory cells, and each column of groups of memory cells including a positive bit line coupled to the first and third memory cells of each group of memory cells and a negative bit line coupled to second and fourth memory cells of each group of memory cells;

a row controller circuit configured to receive signed coefficient data for the IMC operation and generate during each of the first and second MAC elaborations a pulsed word line signal for application to the positive word line when the signed coefficient data is positive, and generate a pulsed word line signal for application to the negative word line when the signed coefficient data is negative; and

a column processing circuit coupled to the positive and negative bit lines and configured to: a) sense a first analog signal developed on the positive bit line during the first MAC elaboration; and b) sense a second signal developed on the negative bit line during the second MAC elaboration.

Example 20. The in-memory computation circuit of Example 19, wherein the column processing circuit is further configured to process the first and second analog signals to generate a result of the IMC operation.

Example 21. The in-memory computation circuit of Example 20, wherein the processing of the first and second analog signals to generate the result of the IMC operation comprises determining a difference between the first and second analog signals.

Example 22. The in-memory computation circuit of Example 19, wherein the row controller circuit is further configured to identify a plurality of rows of groups of memory cells to be simultaneously selected for receiving pulsed word line signals during the first and second MAC elaborations of the IMC operation.

Example 23. The in-memory computation circuit of Example 19, wherein the signed coefficient data for the IMC operation is in a signed binary format including a sign bit and a plurality of data bits providing a coefficient value, and wherein the row controller circuit is further configured to control a pulse width of the pulsed word line signal dependent on the coefficient value.

Example 24. The in-memory computation circuit of Example 23, wherein the row controller circuit comprises, for each row of groups of memory cells:

a data latch configured to latch the sign bit and plurality of data bits for the signed coefficient data;

a counter circuit configured to generate an incrementing count value; and

a comparison circuit configured to compare the coefficient value specified by the latched plurality of data bits to the incrementing count value and control a trailing edge of the pulse width of the pulsed word line signal based on the comparison.

Example 25. The in-memory computation circuit of Example 23, wherein the row controller circuit comprises, for each row of groups of memory cells:

a data latch configured to latch the sign bit and plurality of data bits for the signed coefficient data;

wherein the sign bit provides a control signal for selecting one of the positive and negative word lines for application of the pulsed word line signal;

a first logic gate having a first input coupled to receive the control signal, a second input configured to receive the pulsed word line signal, and an output coupled to the positive word line; and

a second logic gate having a first input coupled to receive a logical inverse of the control signal, a second input configured to receive the pulsed word line signal, and an output coupled to the negative word line.

Example 26. The in-memory computation circuit of Example 25, further including a set-reset flip flop configured to generate the pulsed word line signal.

Example 27. The in-memory computation circuit of Example 26, wherein a first state of the set-reset flip flop is controlled by a start of each of the first and second MAC elaborations and a second state of the set-reset flip flop is controlled by a timing circuit.

Example 28. The in-memory computation circuit of Example 27, wherein the timing circuit comprises:

a counter circuit configured to generate an incrementing count value; and

a comparison circuit configured to compare the coefficient value specified by the latched plurality of data bits to the incrementing count value and generate a signal controlling the second state based on the comparison.

**Claims**

1. An in-memory computation circuit, comprising:

a memory array (112; 212) including a plurality of memory cells (114; 214) arranged in a matrix with plural rows and plural columns, wherein groups ($115_{AB}$; $215_{AB}$) of memory cells store computational weights for an in-memory compute (IMC) operation that is performed with a first multiply and accumulate (MAC) elaboration and a second MAC elaboration, each row of groups of memory cells including a positive word line (WL<B>+) coupled to a first memory cell in each group of memory cells and a negative word line (WL<B>-) coupled to a second memory cell in each group of memory cells, and each column of groups of memory cells including a bit line (BL) coupled to the first and second memory cells of each group of memory cells;

a row controller circuit (118; 218; 218') configured to receive signed coefficient data for the IMC operation and: a) generate during the first MAC elaboration a pulsed word line signal for application to the positive word line when the signed coefficient data is positive, and generate a pulsed word line signal for application to the negative word line when the signed coefficient data is negative; and b) generate during the second MAC elaboration a pulsed word line signal for application to the negative word line when the signed coefficient data is positive, and generate a pulsed word line signal for application to the positive word line when the signed coefficient data is negative; and

a column processing circuit (120; 220) coupled to the bit line and configured to: a) sense a first analog signal developed on the bit line during the first MAC elaboration; and b) sense a second signal developed on the bit line during the second MAC elaboration.

2. The in-memory computation circuit of claim 1, wherein the column processing circuit (120; 220) is further configured to process the first and second analog signals to generate a result of the IMC operation.

3. The in-memory computation circuit of claim 2, wherein the processing of the first and second analog signals to generate the result of the IMC operation comprises determining a difference between the first and second analog signals.

4. The in-memory computation circuit of any of the preceding claims, wherein the row controller circuit (118; 218; 218') is further configured to identify a plurality of rows of groups of memory cells ($115_{AB}$; $215_{AB}$) to be simultaneously selected for receiving pulsed word line signals during the first and second MAC elaborations of the IMC operation.

5. The in-memory computation circuit of any of the preceding claims, wherein the signed coefficient data for the IMC operation is in a signed binary format including a sign bit and a plurality of data bits providing a coefficient value, and wherein the row controller circuit (118; 218; 218') is further configured to control a pulse width of the pulsed word line signal dependent on the coefficient value.

6. The in-memory computation circuit of claim 5, wherein the row controller circuit (118; 218) comprises, for each row of groups of memory cells:

a data latch ($152_B$; $252_B$) configured to latch the sign bit and plurality of data bits for the signed coefficient data;
a counter circuit (154; 254) configured to generate an incrementing count value; and
a comparison circuit ($156_B$; $256_B$) configured to compare the coefficient value specified by the latched plurality of data bits to the incrementing count value and control a trailing edge of the pulse width of the pulsed word line signal based on the comparison.

**7.** The in-memory computation circuit of claim 5, wherein the row controller circuit (218) comprises, for each row of groups of memory cells:

a data latch ($252_B$) configured to latch the sign bit and plurality of data bits for the signed coefficient data;
logic circuitry ($260_B$) having a first input coupled to receive the sign bit, a second input coupled to receive an elaboration indication signal having a first logic state during the first MAC elaboration and having a second logic state during the second MAC elaboration, and an output configured to generate a control signal for selecting one of the positive and negative word lines for application of the pulsed word line signal.

**8.** The in-memory computation circuit of claim 7, further including:

a first logic gate ($262_B$) having a first input coupled to receive the control signal, a second input configured to receive the pulsed word line signal, and an output coupled to the positive word line; and
a second logic gate ($264_B$) having a first input coupled to receive a logical inverse of the control signal, a second input configured to receive the pulsed word line signal, and an output coupled to the negative word line.

**9.** The in-memory computation circuit of any of the claims 1-5, further including a set-reset flip flop ($258_B$; $258_B$) configured to generate the pulsed word line signal.

**10.** The in-memory computation circuit of claim 9, wherein a first state of the set-reset flip flop is controlled by a start of each of the first and second MAC elaborations and a second state of the set-reset flip flop is controlled by a timing circuit (154, 254, 354; 156, 256, 356).

**11.** The in-memory computation circuit of claim 10, when dependent on claim 6 or 7, wherein the timing circuit comprises:

a counter circuit (154; 254; 354) configured to generate an incrementing count value; and
a comparison circuit (156; 256; 356) configured to compare the coefficient value specified by the latched plurality of data bits to the incrementing count value and generate a signal controlling the second state based on the comparison.

**12.** The in-memory computation circuit of any of the claims 1-4, wherein the signed coefficient data for the IMC operation is in a signed 2's complement format including a sign bit and a plurality of data bits providing a coefficient value, and wherein the row controller circuit is further configured to control a pulse width of the pulsed word line signal dependent on the coefficient value.

**13.** The in-memory computation circuit of claim 12, wherein the row controller circuit (218') comprises, for each row of groups of memory cells:

a data latch ($352_B$) configured to latch the sign bit and plurality of data bits for the signed coefficient data;
a first counter circuit configured to generate a first incrementing count value (Countp);
a second counter circuit configured to generate a second incrementing count value (Countn);
a first comparison circuit ($356p_B$) enabled by a first logic state of the sign bit to compare the coefficient value specified by the latched plurality of data bits to the first incrementing count value and control a trailing edge of the pulse width of the pulsed word line signal based on the first comparison; and
a second comparison circuit ($356n_B$) enabled by a second logic state of the sign bit to compare the coefficient value specified by the latched plurality of data bits to the second incrementing count value and control the trailing edge of the pulse width of the pulsed word line signal based on the second comparison.

**14.** The in-memory computation circuit of claim 12, wherein the row controller circuit (218') comprises, for each row of groups of memory cells:

a data latch ($352_B$) configured to latch the sign bit and plurality of data bits for the signed coefficient data;

logic circuitry (260$_B$) having a first input coupled to receive the sign bit, a second input coupled to receive an elaboration indication signal having a first logic state during the first MAC elaboration and having a second logic state during the second MAC elaboration, and an output configured to generate a control signal for selecting one of the positive and negative word lines for application of the pulsed word line signal.

15. The in-memory computation circuit of claim 14, further including:

a first logic gate (362$_B$) having a first input coupled to receive the control signal, a second input configured to receive the pulsed word line signal, and an output coupled to the positive word line; and
a second logic gate (364$_B$) having a first input coupled to receive a logical inverse of the control signal, a second input configured to receive the pulsed word line signal, and an output coupled to the negative word line.

FIG. 1

FIG. 2

FIG. 3

FIG. 6

FIG. 4

FIG. 5

FIG. 7

FIG. 8

FIG. 9

t1    t2 t3    t4    t5 t6 t7 t8 t9    t10   t11 t12 t13 t14

FIG. 11

t1    t2 t3    t4    t5 t6 t7 t8 t9    t10   t11 t12 t13 t14

FIG. 10

Europäisches
Patentamt

European
Patent Office

Office européen
des brevets

# EUROPEAN SEARCH REPORT

Application Number

EP 23 21 2542

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SI XIN ET AL: "A Twin-8T SRAM Computation-in-Memory Unit-Macro for Multibit CNN-Based AI Edge Processors", IEEE JOURNAL OF SOLID-STATE CIRCUITS, IEEE, USA, vol. 55, no. 1, 27 December 2019 (2019-12-27), pages 189-202, XP011763111, ISSN: 0018-9200, DOI: 10.1109/JSSC.2019.2952773 [retrieved on 2019-12-26] * page 191, left-hand column, paragraph 3 - page 194, right-hand column, paragraph 4; figures 3-7; tables I-III * | 1-15 | INV. G11C7/10 G11C11/54 G11C8/08 G11C13/00 G06F7/544 G06N3/063 |
| X | US 2021/390382 A1 (KWON SOONWAN [KR] ET AL) 16 December 2021 (2021-12-16) * paragraph [0078] - paragraph [0161]; figures 9B, 12 * | 1-15 | |
| A | BHARTI PRAMOD KUMAR ET AL: "Compute-In-Memory Using 6T SRAM for a Wide Variety of Workloads", 2022 IEEE INTERNATIONAL SYMPOSIUM ON CIRCUITS AND SYSTEMS (ISCAS), IEEE, 27 May 2022 (2022-05-27), pages 2963-2967, XP034224604, DOI: 10.1109/ISCAS48785.2022.9937781 [retrieved on 2022-11-11] * page 2963, right-hand column, last paragraph - page 2966, right-hand column, paragraph 2; figures 1,2 * | 1-15 | TECHNICAL FIELDS SEARCHED (IPC) G11C G06N G06F |
| A | WO 2021/041139 A1 (GOOGLE LLC [US]) 4 March 2021 (2021-03-04) * paragraph [0023] - paragraph [0049]; figures 1-3 * | 1-15 | |

The present search report has been drawn up for all claims

| Place of search | Date of completion of the search | Examiner |
|---|---|---|
| The Hague | 9 April 2024 | Colling, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 2542

This annex lists the patent family members relating to the patent documents cited in the above-mentioned European search report.
The members are as contained in the European Patent Office EDP file on
The European Patent Office is in no way liable for these particulars which are merely given for the purpose of information.

09-04-2024

| Patent document cited in search report | | Publication date | Patent family member(s) | | Publication date |
|---|---|---|---|---|---|
| US 2021390382 | A1 | 16-12-2021 | CN | 113807493 A | 17-12-2021 |
| | | | EP | 3923204 A2 | 15-12-2021 |
| | | | JP | 2021197176 A | 27-12-2021 |
| | | | KR | 20210154502 A | 21-12-2021 |
| | | | US | 2021390382 A1 | 16-12-2021 |
| WO 2021041139 | A1 | 04-03-2021 | CN | 114341796 A | 12-04-2022 |
| | | | EP | 3987388 A1 | 27-04-2022 |
| | | | JP | 2022544854 A | 21-10-2022 |
| | | | KR | 20220031098 A | 11-03-2022 |
| | | | TW | 202109281 A | 01-03-2021 |
| | | | TW | 202319909 A | 16-05-2023 |
| | | | US | 2022283777 A1 | 08-09-2022 |
| | | | WO | 2021041139 A1 | 04-03-2021 |

EPO FORM P0459

For more details about this annex : see Official Journal of the European Patent Office, No. 12/82